# EUROPEAN PATENT APPLICATION

(11) **EP 2 728 683 A1**
(43) Date of publication of application: **07.05.2014**
(21) Application number: 12805410.3
(22) Date of filing: 29.06.2012
(51) Int. Cl.: H01S 5/042, H01S 5/343

(54) **GROUP III NITRIDE SEMICONDUCTOR ELEMENT AND METHOD FOR MANUFACTURING GROUP III NITRIDE SEMICONDUCTOR ELEMENT**

(30) Priority: 29.06.2011 JP 2011144664; 15.05.2012 JP 2012111478
(71) Applicant: Sumitomo Electric Industries, Ltd., Osaka 541 0041 (JP); Sony Corporation, Tokyo 108-0075 (JP)
(72) Inventor: ENYA Yohei, Itami-shi Hyogo 664-0016 (JP); YOSHIZUMI Yusuke, Itami-shi Hyogo 664-0016 (JP); KYONO Takashi, Osaka-shi Osaka 554-0024 (JP); SUMITOMO Takamichi, Itami-shi Hyogo 664-0016 (JP); UENO Masaki, Itami-shi Hyogo 664-0016 (JP); YANASHIMA Katsunori, Tokyo 108-0075 (JP); TASAI Kunihiko, Tokyo 108-0075 (JP); NAKAJIMA Hiroshi, Tokyo 108-0075 (JP)
(74) Representative: Grünecker, Kinkeldey, Stockmair & Schwanhäusser
(86) International application number: PCT/JP2012/066769
(87) International publication number: WO 2013/002389

(57) **Abstract**

A group-III nitride semiconductor device and a method of fabricating the same are provided, and the group-III nitride semiconductor device has p-type contact layers with a relatively smaller contact resistance and a relatively higher carrier concentration without reducing the crystallinity, and comprises a contact layer 25a which is provided on the active layer 17, a contact layer 25b in direct contact with the contact layer 25a, and an electrode 37, which is provided on the contact layer 25b, in direct contact with the contact layer 25a. The contact layer 25a and the contact layer 25b comprise the same material of p-type conductivity. The p-type dopant concentration of the contact layer 25a is lower than that of the contact layer 25b, and a junction J1 between the contact layer 25a and the contact layer 25b is tilted at an angle of not less than 50 degrees to less than 130 with respect to the plane Sc that is orthogonal to the reference axis Cx intending along the c-axis.

## Description

### Technical Field

The present invention relates to a group-III nitride semiconductor device and a method of fabricating a group-III nitride semiconductor device.

### Background Art

Patent Literature 1 discloses technology related to light emitting devices that can be driven by a decreased voltage.

### Citation List

### Patent Literature

Non-Patent Literatures 1 and 2 disclose calculations concerning piezoelectric fields.

Patent Literature 1: Japanese Unexamined Patent Application Publication No. 08-97471

### Non-Patent Literature

Non-Patent Literature 1: Japanese Journal of Applied Physics, Vol. 39 (2000) pp. 413
Non-Patent Literature 2: Journal of Applied Physics, Vol. 91 No. 12 (2002) pp. 9904

### Summary of Invention

### Technical Problem

Patent Literature 1 discloses that the following layers are grown on a sapphire substrate: a 500-angstrom thick AIN buffer layer; a high-level carrier concentration n⁺ layer of Si-doped GaN having an electron concentration of 2×10¹⁸ cm³ and a thickness of approximately 2.0 µm;, a high-level carrier n⁺ layer of Si-doped (Alₓ₂Ga₁₋ₓ₂)_{y2}In_{1-y2}N having a thickness of approximately 2.0 µm and an electron concentration of 2×10¹⁸ cm³, a p-type conductivity light emitting layer of Mg-, Zn-, and Si-doped (Alₓ₁Ga₁₋ₓ₁)_{y1}In_{1-y1}N having a thickness of approximately 0.5 µm, a p-layer Mg-doped (Alₓ₂Ga₁₋ₓ₂)_{y2}Iu_{1-y2}N having a thickness of approximately 1.0 µm and a hole concentration of 2×10¹⁷ cm³, a second contact layer of Mg-doped GaN having a thickness of approximately 0.2 µm and a hole concentration of 5×10¹⁷ cm³, and a first contact layer of Mg-doped GaN having a thickness of approximately 500 angstrom, a hole concentration of 2×10¹⁷ cm³, and a Mg concentration of 2×10²⁰ cm³. Additionally, two electrodes of nickel are formed such that the two electrodes are connected to the p-layer and the high-level carrier n⁺ layer, respectively.

The light emitting device in Patent Literature 1, in particular, includes a p-type first contact layer of a high Mg concentration provided on the outermost surface formed above the c-plane sapphire substrate and a p-type second contact layer of a low Mg concentration located under the first contact layer. The Mg concentration of the first contact layer is in the range of 1×10²⁰ and 1×10²¹ cm⁻³, whereas the Mg concentration of the second contact layer is in the range of 1×10¹⁹ and 5×10²⁰ cm⁻³. Thickness values, 50 and 200 nm, for the first and second contact layers are disclosed.

The contact resistance of the Mg-doped p-type gallium nitride contact layer varies depending on the Mg concentration. The contact resistance is relatively lower at an Mg concentration of approximately 1×10²⁰ cm⁻³. Such a high Mg concentration impairs the crystallinity, causing a decrease in the p-type carrier concentration. Hence, what is needed is a group-III nitride semiconductor device having a p-type contact layer of low contact resistance, high crystallinity, and an appropriate carrier concentration of which are satisfactory.

It is an object of the present invention to provide a group-III nitride semiconductor device and a method of the same, and the group-III nitride semiconductor device includes a p-type contact layer that has a relatively low contact resistance and a relatively high carrier concentration without reducing its crystallinity.

### Solution to Problem

A group-III nitride semiconductor device according to the present invention includes a gallium nitride-based semiconductor light emitting layer; a first contact layer provided over the light emitting layer; a second contact layer provided over the first contact layer and in direct contact with the first contact layer; and a metal electrode provided over the second contact layer and in direct contact with the second contact layer. The p-type gallium nitride-based semiconductor of the first contact layer is the same as that of the second contact layer; the p-type dopant concentration of the first contact layer is lower than the p-type dopant concentration of the second contact layer; the interface between the first contact layer and the second contact layer is inclined at an angle larger than or equal to 50 degrees and smaller than 130 degrees with respect to a plane orthogonal to the reference axis that extends along a c-axis thereof; the wavelength of light emitted from the light emitting layer is within the range of 480 to 600 nm; the second contact layer has a thickness within the range of 1 to 50 nm, and the second contact layer has a thickness within the range of 1 to 20 nm.

In the second contact layer, the relatively higher p-type dopant concentration leads to a decrease in the contact resistance to the metal electrode, and the relatively smaller thickness thereof makes the crystallinity relatively higher. In the first contact layer, the relatively lower p-type dopant concentration makes the crystallinity better and is effective in making the carrier concentration relatively higher. This achieves low contact resistance between the second contact layer and the metal electrode and enables the carrier concentration to become high without reducing the crystallinity. The piezoelectric field is relatively small or zero, and its direction is opposite to the direction in the case of a tilt angle of smaller than 50 degrees or larger than or equal to 130 degrees at the interface between the first contact layer and the second contact layer. Thus, the aspect of the present invention can improve the external quantum efficiency and other factors of the light emitting layer, when compared with the case of an interface tilting at an angle of smaller than 50 degrees or not less than 130 degrees.

It is preferred that the group-III nitride semiconductor device according to the present invention further include a p-type gallium nitride-based semiconductor cladding layer, wherein the cladding layer is provided between the light emitting layer and the first contact layer, the bandgap of the cladding layer is larger than the bandgap of the first contact layer, and the first contact layer is in direct contact with the cladding layer.

It is preferred that the group-III nitride semiconductor device according to the present invention further include a substrate comprising a gallium nitride-based semiconductor. The light emitting layer, the cladding layer, the first contact layer, the second contact layer, and the metal electrode are arranged in sequence over a primary surface of the substrate, and the primary surface tilts at an angle in the range of larger than or equal to 50 degrees and smaller than 130 degrees from the plane that is orthogonal to the reference axis. Since a substrate composed of a gallium nitride semiconductor can be used, gallium nitride-based semiconductor layers are grown over the primary surface, which is inclined at an angle in the range of larger than or equal to 50 degrees and smaller than 130 degrees from a surface orthogonal to the reference axis, and the interface between the first contact layer and the second contact layer is also inclined at the same angle as that of the primary surface.

It is preferred that, in the group-III nitride semiconductor device according to the present invention, the concentration of p-type dopant of the first contact layer be 5×10²⁰ cm⁻³ or lower, and the concentration of the p-type dopant of the second contact layer be within the range of 1×10²⁰ to 1×10²¹ cm⁻³. Such a relatively higher p-type dopant concentration of the second contact layer, which is in direct contact with the metal electrode, makes the contact resistance to the metal electrode relatively lower.

It is preferred that, in the group-III nitride semiconductor device according to the present invention, the concentration of the p-type dopant of the first contact layer be within the range of 5×10¹⁸ to 5×10¹⁹ cm⁻³. Such a relatively lower p-type dopant concentration of the first contact layer, which is not in direct contact with the metal electrode, makes the crystallinity relatively higher, leading to a relatively higher carrier concentration.

In the group-III nitride semiconductor device according to the present invention, the p-type dopant preferably comprises magnesium, enabling the efficient supply of the p-type dopant. Magnesium forms a relatively shallow acceptor level in a nitride semiconductor, which makes the activation rate, (the hole concentration)/(the dopant concentration), high, thereby achieving a relatively higher hole concentration at a relatively lower dopant concentration.

In the group-III nitride semiconductor device according to the present invention, the first contact layer and the second contact layer are preferably composed of gallium nitride. GaN is a gallium nitride-based semiconductor of binary compounds, and can provide the first and second contact layers with excellent crystallinity.

In the group-III nitride semiconductor device according to the present invention, the first contact layer and the second contact layer are preferably composed of InₓAl_{y}Ga_{1-x-y}N (0≤x≤1, 0≤y≤1, 0≤1-x-y). Thus, the first and second contact layers can be composed of a gallium nitride-based semiconductor other than GaN. Since use of the gallium nitride-based semiconductor other than GaN changes the lattice mismatch degree to the substrate and the amount of strain incorporated in the contact layers depending thereupon, the carrier concentration of the first contact layer can be increased, and the contact resistance between the second contact layer and the metal electrode can be decreased.

In the group-III nitride semiconductor device according to the present invention, the light emitting layer is preferably composed of InₓGa₁₋ₓN (0.15≤x<0.50). This enables the emission of light having a wavelength within the range of 480 to 600 nm. This indium-containing region increases strain incorporated in the light emitting layer, resulting in a large reduction in the piezoelectric field when the primary surface of the substrate is provided with an inclination angle in the above-mentioned range. Thus, the present aspect of the invention provides a light emitting device that has satisfactorily high external quantum efficiency in the indium-containing region.

In the group-III nitride semiconductor device according to the present invention, the metal electrode is preferably composed of palladium, gold, or an alloy of nickel and gold. A metal electrode composed of such a material achieves excellent contact with the second contact layer. A more satisfactory ohmic junction can be achieved with such metals.

A method of fabricating a group-III nitride semiconductor device according to the present invention comprises the steps of: growing a light emitting layer, the light emitting layer comprising a gallium nitride-based semiconductor; growing a first contact layer on the light emitting layer, the first contact layer comprising a p-type gallium nitride-based semiconductor; after changing amount of p-type dopant supplied in the growth of the first contact layer, growing a second contact layer on the first contact layer, the second contact layer comprising a p-type gallium nitride-based semiconductor; and forming a metal electrode on the second contact layer. A p-type gallium nitride-based semiconductor of the first contact layer is the same as a p-type gallium nitride-based semiconductor of the second contact layer; the amount of p-type dopant supplied to a growth reactor in the growth of the second contact layer is larger than amount of p-type dopant supplied to a growth reactor in the growth of the first contact layer; a growth temperature for the first contact layer and the second contact layer is higher than a growth temperature of an active layer in the light emitting layer; a difference between the growth temperature for the first contact layer and the second contact layer and the growth temperature for the active layer is in a range of 100 degrees Celsius to 350 degrees Celsius; the second contact layer is in direct contact with the metal electrode; the first contact layer is in direct contact with the second layer; an interface between the first contact layer and the second contact layer tilts at an angle of not less than 50 degrees and smaller than 130 degrees from a plane orthogonal to a reference axis extending along a c-axis thereof; the light emitting layer emits light of a wavelength in a range of 480 to 600 nm; and the second contact layer has a thickness in a range of 1 to 50 nm.

The relatively higher p-type dopant concentration of the second contact layer can decrease the contact resistance to the metal electrode, and the relatively smaller thickness leads to relatively higher crystallinity. The relatively lower p-type dopant concentration of the first contact layer leads to the relatively higher crystallinity, which is effective in making the carrier concentration of the first contact layer relatively higher. Accordingly, the contact resistance between the second contact layer and the metal electrode becomes reduced and the carrier concentration becomes increased without deteriorating the crystallinity. The piezoelectric field is small or zero and its direction is inverted as compared with the case of a tilt angle in the range of smaller than 50 degrees or not less than 130 degrees at the interface between the first contact layer and the second contact layer. Hence, the external quantum efficiency and other factors of the light emitting layer can be improved as compared with the case of a tilting interface at an angle smaller than 50 degrees or not less than 130 degrees. The growth temperature of the first and second contact layers is higher than the growth temperature of the light emitting layer. The difference between the growth temperature of the light emitting layer and the growth temperature of the first and second contact layers is in the range of 150 degrees Celsius to 300 degrees Celsius. If the difference in growth temperature is smaller than such a temperature range, the growth temperature of the first and second contact layers is also made low, thereby making the electrical properties worse. If the difference in growth temperature is greater than such a temperature range, the amount of thermal damage that the active layer receives becomes large, thereby making the light emitting efficiency reduced.

It is preferred that the method of fabricating a group-III nitride semiconductor device according to the present invention further include the step of growing a p-type gallium nitride-based semiconductor cladding layer, wherein the cladding layer is grown after the light emitting layer has been grown, the first contact layer and the second contact layer are grown after the cladding layer has been grown, the cladding layer is provided between the light emitting layer and the first contact layer, the bandgap of the cladding layer is greater than the bandgap of the first contact layer, and the first contact layer is in direct contact with the cladding layer,

It is preferred that the method of fabricating a group-III nitride semiconductor device according to the present invention further include the step of preparing a substrate comprising a gallium nitride-based semiconductor, wherein the cladding layer is grown on the substrate; the light emitting layer, the cladding layer, the first contact layer, the second contact layer, and the metal electrode are arranged in sequence over a primary surface of the substrate, and the primary surface is inclined from the plane orthogonal to the reference axis at an angle of larger than or equal to 50 degrees and smaller than 130 degrees. Since the substrate of a gallium nitride semiconductor can be used and the gallium nitride-based semiconductor layers are grown over the primary surface, which tilts by an angle larger than or equal to 50 degrees and smaller than 130 degrees from a surface orthogonal to the reference axis, the interface between the first contact layer and the second contact layer is also inclined at the same angle as the primary surface.

In the method of fabricating a group-III nitride semiconductor device according to the present invention, the p-type dopant concentration of the first contact layer is preferably 5×10²⁰ cm⁻³ or lower, and the p-type dopant concentration of the second contact layer is preferably within the range of 1×10²⁰ to 1×10²¹ cm⁻³. The relatively higher p-type dopant concentration of the second contact layer, which is in direct contact with the metal electrode, can be low the contact resistance to the metal electrode.

In the method of fabricating a group-III nitride semiconductor device according to the present invention, the p-type dopant concentration of the first contact layer is preferably within the range of 5×10¹⁸ to 5×10¹⁹ cm⁻³. The relatively lower p-type dopant concentration of the first contact layer, which is not in direct contact with the metal electrode, is effective in making the crystallinity of the first contact layer relatively higher, leading to the relatively higher carrier concentration.

In the method of fabricating a group-III nitride semiconductor device according to the present invention, the p-type dopant preferably comprises magnesium, which allows efficient supply of the p-type dopant. Magnesium forms a relatively shallow acceptor level in a nitride semiconductor, and is effective in making the activation rate, (the hole concentration)/(the dopant concentration), higher, thereby achieving a relatively high hole concentration at a relatively low dopant concentration.

In the method of fabricating a group-III nitride semiconductor device according to the present invention, the first contact layer and the second contact layer are preferably composed of gallium nitride. GaN is a gallium nitride semiconductor of a binary compound, and can provide the first and second contact layers of GaN with excellent crystallinity.

In the method of fabricating a group-III nitride semiconductor device according to the present invention, the first contact layer and the second contact layer are preferably composed of InₓAl_{y}Ga_{1-x-y}N (0≤x≤1, 0≤y≤1, 0≤1-x-y). Thus, the first and second contact layers can be composed of a gallium nitride-based semiconductor other than GaN. Use of the gallium nitride-based semiconductor other than GaN changes the lattice mismatch degree to the substrate, which changes the amount of strain incorporated in the contact layers, so that the carrier concentration of the first contact layer can be made high, and the contact resistance between the second contact layer and the metal electrode can be made low.

In the method of fabricating a group-III nitride semiconductor device according to the present invention, the light emitting layer is preferably composed of InₓGa₁₋ₓN (0.15≤x<0.50). This light emitting layer enables the emission of light having a wavelength within the range of 480 to 600 nm. This indium-containing region increases strain incorporated in the light emitting layer, allowing a large reduction in the piezoelectric field when the primary surface of the substrate is provided with an inclination angle in the above-mentioned range. Thus, the present aspect of the invention provides a light emitting device that has satisfactorily high external quantum efficiency in the indium-containing region.

In the group-III nitride semiconductor device according to the present invention, the carbon impurity concentration of the first contact layer is preferably 1×10¹⁷ cm⁻³ or lower. The relatively lower concentration of the carbon impurity satisfactorily reduces the contact resistance and the operating voltage of the device.

In the group-III nitride semiconductor device according to the present invention preferably, the primary surface of the substrate is inclined from a plane orthogonal to the reference axis at an angle of larger than or equal to 70 degrees and smaller than 80 degrees. The use of a substrate having such an angle range reduces the variation in the In content in the light emitting layer and enables the production of a light emitting device having satisfactorily high external quantum efficiency.

In the group-III nitride semiconductor device according to the present invention, the primary surface of the substrate tilts preferably at an angle of larger than or equal to 100 degrees and smaller than 110 degrees from the plane that is orthogonal to the reference axis. The use of a tilting substrate by such an angle range reduces a fluctuation in the In content in the light emitting layer and enables the production of a light emitting device having satisfactorily high external quantum efficiency.

In the method of fabricating a group-III nitride semiconductor device according to the present invention, the growth rate of the first contact layer is preferably 1 µm/hour or lower, the growth rate of the second contact layer is preferably 0.1 µm/hour or lower, the growth rate of the second contact layer is preferably lower than the growth rate of the first contact layer, and the first and second contact layers are preferably grown in an atmosphere having a hydrogen content of 20% or more. Since hydrogen is used as atmosphere gas in growth of the first and second contact layers, and the growth rates of the first and second contact layers are relatively low, the ratio of the number of group-V atoms to the number of group-III atoms can be made higher in the growth of the first and second contact layers. Thus, the carbon impurity concentration of the first and second contact layers can be made relatively lower and the relatively lower carbon impurity concentration satisfactorily reduces the contact resistance and the operating voltage of the device.

In the method of fabricating a group-III nitride semiconductor device according to the present invention, the carbon impurity concentration of the first contact layer is preferably 1×10¹⁷ cm⁻³ or lower. The relatively lower concentration of carbon satisfactorily reduces the contact resistance and the operating voltage of the device.

In the method of fabricating a group-III nitride semiconductor device according to the present invention, the difference between the growth temperature of the first contact layer and second contact layer and the growth temperature of the active layer is preferably in the range of 100 degrees Celsius to 250 degrees Celsius, A growth temperature in such a temperature range can make the crystallinity of the contact layers better, and reduce the damage applied to the active layer during growth of the contact layers.

In the method of fabricating a group-III nitride semiconductor device according to the present invention, the primary surface of the substrate tilts preferably at an angle larger than or equal to 70 degrees and smaller than 80 degrees with respect to a plane orthogonal to the reference axis. The use of the tilting substrate in such an angle range reduces a fluctuation in the In content in the light emitting layer and enables the production of a light emitting device having satisfactorily high external quantum efficiency.

In the method of fabricating a group-III nitride semiconductor device according to the present invention, the primary surface of the substrate tilts preferably at an angle of larger than or equal to 100 degrees and smaller than 110 degrees from the plane that is orthogonal to the reference axis. The use of the tilting substrate in such an angle range reduces the fluctuation in the In content in the light emitting layer and enables the production of a light emitting device having satisfactorily high external quantum efficiency.

In the method of fabricating a group-III nitride semiconductor device according to the present invention, the growth temperature of the active layer is preferably higher than or equal to 650 degrees Celsius and lower than 800 degrees Celsius. This allows for the production of the active layer that emits light in the above-mentioned wavelength range (i.e., in the range of 480 to 600 nm).

In the method of fabricating a group-III nitride semiconductor device according to the present invention, the metal electrode preferably comprises palladium, gold, or an alloy of nickel and gold, A metal electrode composed of such a material achieves excellent contact with the second contact layer. A more satisfactory ohmic junction can be achieved with such metals.

### Advantageous Effects of Invention

The present invention can provide a group-III nitride semiconductor device having a p-type contact layer that has a relatively low contact resistance and a relatively high carrier concentration without reducing its crystallinity, and can provide a method of fabricating the same.

### Brief Description of Drawings

Fig. 1 is a schematic view showing a group-III nitride-based semiconductor device according to an embodiment.
Fig. 2 is a view showing primary steps in a method of fabricating a group-III nitride-based semiconductor device according to an embodiment.
Fig. 3 is a schematic view of products formed in the respective steps in the method of fabricating a group-III nitride-based semiconductor device according to an embodiment.
Fig. 4 is a view showing the device structure and the growth temperature for a laser diode according to Example 1.
Fig. 5 is a view showing the device structure and the growth temperature for a laser diode according to Example 2.
Fig. 6 is a view showing a luminous efficiency curve, and the relationship between external quantum efficiency and the wavelength of emitted light.
Fig. 7 is a view illustrating the relationship between piezoelectric field and off-angle of the primary surface.
Fig. 8 is a view illustrating the relationship between the magnesium concentration and the carrier concentration.
Fig. 9 is a view illustrating the relationship between the magnesium concentration and the contact resistance.
Fig. 10 is a view illustrating an advantageous effect of the embodiment.
Fig. 11 is a view illustrating the results of SIMS analysis of the epitaxial layered structure from the surface.
Fig. 12 is a view illustrating the device structure and growth temperature for a laser diode according to Example 6.
Fig. 13 is a view illustrating the part of the profiles of the SIMS analysis of the epitaxial layered structure according to Example 6 from the surface.
Fig. 14 is a view illustrating the part of the profiles of the SIMS analysis of the epitaxial layered structure according to Example 6 from the front surface.
Fig. 15 is a view illustrating the part of the profiles of the SIMS analysis of the epitaxial layered structure according to Example 6 from the front surface.

### Description of Embodiments

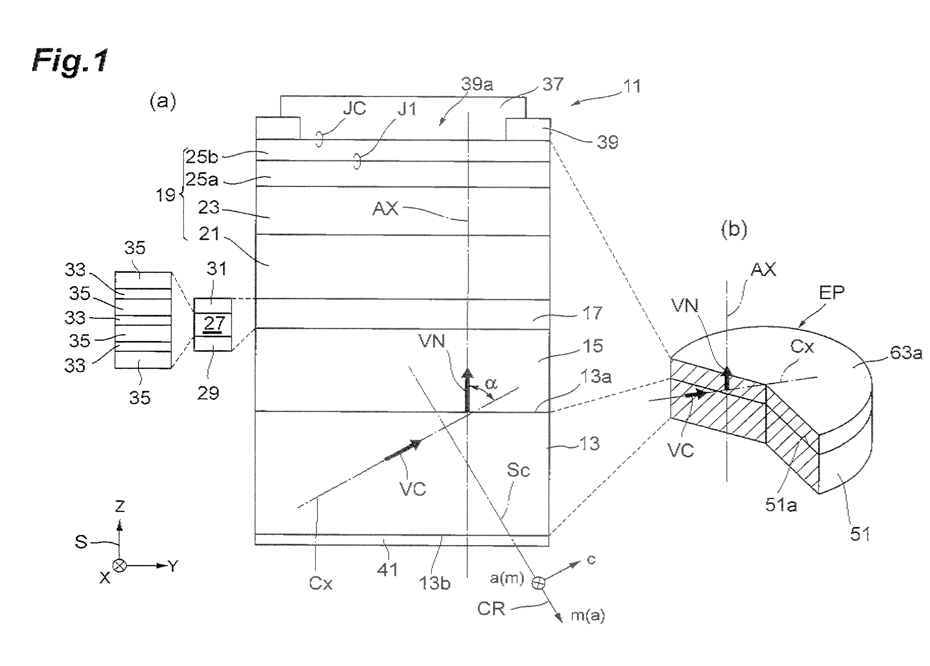

The teaching of the invention can be easily understood through the detailed descriptions described below with reference to the accompanying exemplary drawings. A group-III nitride semiconductor device and a method of fabricating a group-III nitride semiconductor device according to embodiments will now be described in detail with reference to the accompanying drawings. The same elements will be designated by the same reference numerals, it possible. Fig. 1 is a schematic view of the structure of the group-III nitride semiconductor device and an epitaxial substrate of the group-III nitride semiconductor device according to an embodiment. Light emitting devices, such as a light emitting diode and a laser diode are explained below as the group-III nitride semiconductor device 11, but the present embodiments, however, are applicable to other group-III nitride semiconductor devices which include a p-type group-III nitride semiconductor.

Part (a) of Fig. 1 illustrates the group-III nitride semiconductor device 11, and part (b) of Fig. 1 illustrates an epitaxial substrate EP of the group-III nitride semiconductor device 11.

The epitaxial substrate EP has an epitaxial layer structure like that of the group-III nitride semiconductor device 11. The semiconductor layers that constitute the group-III nitride semiconductor device 11 will now be described. The epitaxial substrate EP includes semiconductor layers (semiconductor films) corresponding to the semiconductor layers of the group-III nitride semiconductor device 11. The description of the semiconductor layers of the group-III nitride semiconductor device 11 is also applied to the corresponding semiconductor layers of the epitaxial substrate EP.

Fig. 1 illustrates a coordinate system "S" and a crystal coordinate system "CR." The primary surface 13a of a substrate 13 is orthogonal to the Z-axis and extends in the X and Y directions. The X-axis extends along the a-axis. As illustrated in Part (a) of Fig. 1, the group-III nitride semiconductor device 11 includes the substrate 13, an n-type group-III nitride semiconductor region 15, a light emitting layer 17, and a p-type group-III nitride semiconductor region 19. The n-type group-III nitride semiconductor region 15, the light emitting layer 17, and the p-type group-III nitride semiconductor region 19 are epitaxially grown over the substrate 13.

The c-plane of the substrate 13 extends along a plane Sc, as illustrated in Fig. 1, The crystal coordinate system CR (c-axis, a-axis, and m-axis) is illustrated on the plane Sc to indicate the crystal axes of a hexagonal gallium nitride semiconductor. The primary surface 13a of the substrate 13 tilts at an angle α toward one of the m-axis and the a-axis of the gallium nitride semiconductor of the substrate 13 with reference to the plane Sc orthogonal to the reference axis Cx. The tilt angle a is defined by a normal vector VN of the primary surface 13a of the substrate 13 and a c-axis vector VC indicating the reference axis Cx. On the primary surface 13a , the light emitting layer 17 is provided between the n-type group-III nitride semiconductor region 15 and the p-type group-III nitride semiconductor region 19. The n-type group-III nitride semiconductor region 15, the light emitting layer 17, and the p-type group-III nitride semiconductor region 19 are arrayed in sequence along the normal vector VN (Z direction) on the primary surface 13a. An n-side optical guiding layer 29, an active layer 27, and a p-side optical guiding layer 31 are arrayed in sequence along the normal vector VN (Z direction) in the light emitting layer 17 over the primary surface 13a. A p-type gallium nitride-based semiconductor layer 21, a p-type cladding layer 23, a contact layer 25a, and a contact layer 25b are arrayed in sequence along the normal vector VN (Z direction) in the p-type group-III nitride semiconductor region 19 over the primary surface 13a.

The substrate 13 has the primary surface 13a composed of a conductive gallium nitride-based semiconductor. The primary surface 13a of the substrate 13 tilts by an angle larger than or equal to 50 degrees and smaller than 130 degrees from the plane Sc orthogonal to the reference axis Cx extending along the c-axis of the gallium nitride-based semiconductor. The substrate 13, including the primary surface 13a, may be composed of a gallium nitride-based semiconductor. The gallium nitride-based semiconductor of the substrate 13 is composed of, for example, gallium nitride (GaN), indium gallium nitride (InGaN), or aluminum gallium nitride (AlGaN). GaN, which is a binary compound, can provide excellent crystal quality and a stable substrate surface. Instead, the substrate 13 may be composed of AlN.

The n-type group-III nitride semiconductor region 15 is composed of an n-type gallium nitride-based semiconductor. The n-type group-III nitride semiconductor region 15 is provided over the substrate 13. The n-type group-III nitride semiconductor region 15 is in direct contact with the primary surface 13a of the substrate 13. The n-type group-III nitride semiconductor region 15 includes at least one n-type gallium nitride-based semiconductor layer. This n-type gallium nitride-based semiconductor layer is provided over the primary surface 13a. The n-type group-III nitride semiconductor region 15 includes, for example, an n-type buffer layer, an n-type cladding layer, and an n-type optical guiding layer. The n-type group-III nitride semiconductor region 15 is composed of, for example, n-type GaN, InGaN, AlGaN, or InAlGaN.

The light emitting layer 17 is composed of, for example, a gallium nitride-based semiconductor containing indium (In). The light emitting layer 17 is provided over the substrate 13 and the n-type group-III nitride semiconductor region 15. The light emitting layer 17 is in direct contact with the n-type group-III nitride semiconductor region 15. The light emitting layer 17 includes the active layer 27 and, if required, may include the n-side optical guiding layer 29 and the p-side optical guiding layer 31. The active layer 27 includes at least one well layer 33 and plural barrier layers 35. Each of the barrier layers 35 has a bandgap greater than that of the well layer 33. The active layer 27 may have a single or multiple quantum well structure. The well layer 33 and the barrier layers 35 are arranged over the n-type group-III nitride semiconductor region 15 and the n-side optical guiding layer 29. The well layer 33 and the barrier layers 35 are composed of, for example, AlGaN, GaN, InGaN, or InAlGaN. The wavelength of the light that is emitted from the light emitting layer 17 (active layer 27) is, for example, in the range of 480 to 600 nm. The electrical property of the p-type gallium nitride-based semiconductor can be improved in the light emitting device that generates light in such a wavelength range. The property of the p-type gallium nitride-based semiconductor can be also improved in the light emitting device generating long-wavelength light.

The light emitting layer 17 is composed of a gallium nitride-based semiconductor containing indium (In) and has an indium content larger than or equal to 15% and smaller than 50%. Accordingly, the light emitting layer 17 can generate light having wavelength within the range of 480 to 600 nm. For example, the light emitting layer 17 is composed of InₓGa₁₋ₓN (0.15≤x<0.50).

The p-type group-III nitride semiconductor region 19 is composed of a p-type gallium nitride-based semiconductor. The p-type dopant of the p-type group-III nitride semiconductor region 19 is magnesium (Mg), which allows smooth supply of the p-type dopant. Instead, the p-type dopant can comprise zinc (Zn). The p-type group-III nitride semiconductor region 19 is provided on the substrate 13, the n-type group-III nitride semiconductor region 15, and the light emitting layer 17. The p-type group-III nitride semiconductor region 19 is in direct contact with the light emitting layer 17. The p-type group-III nitride semiconductor region 19 includes one or more p-type gallium nitride-based semiconductor layers. The p-type group-III nitride semiconductor region 19 includes, for example, the p-type gallium nitride-based semiconductor layer 21. The p-type gallium nitride-based semiconductor layer 21 is provided on the light emitting layer 17 and is in direct contact with the light emitting layer 17. The p-type gallium nitride-based semiconductor layer 21 may include a p-type electron-blocking layer and a p-type optical guiding layer. The p-type group-III nitride semiconductor region 19 further includes, for example, the p-type cladding layer 23. The p-type cladding layer 23 is provided over the p-type gallium nitride-based semiconductor layer 21 and is in direct contact with the p-type gallium nitride-based semiconductor layer 21. The p-type gallium nitride-based semiconductor layer 21 and the p-type cladding layer 23 are composed of, for example, p-type GaN, InGaN, AlGaN, or InAlGaN.

The p-type group-III nitride semiconductor region 19 includes, for example, the contact layer 25a (first contact layer). The contact layer 25a is provided over the p-type cladding layer 23 and is in direct contact with the p-type cladding layer 23. The p-type group-III nitride semiconductor region 19 includes, for example, the contact layer 25b (second contact layer). The contact layer 25b is provided over the contact layer 25a and is in direct contact with the contact layer 25a.

An interface J1 is formed between the contact layer 25a and the contact layer 25b. The contact layer 25a and the contact layer 25b are composed of the same p-type gallium nitride-based semiconductor, such as p-type GaN. Since GaN is a binary compound, the contact layer 25a and contact layer 25b composed of GaN have excellent crystal quality.

The p-type dopant concentration of the contact layer 25a is lower than that of the contact layer 25b. The p-type dopant concentration of the contact layer 25a is 5×10²⁰ cm⁻³ or less. For example, the p-type dopant concentration of the contact layer 25a is in the range of 5×10¹⁸ to 5×10¹⁹ cm⁻³. The relatively lower p-type dopant concentration of the contact layer 25a, which is not in direct contact with an electrode 37, leads to relatively high crystallinity and, thus a relatively higher carrier concentration. The p-type dopant concentration of the contact layer 25b is in the range of 1×10²⁰ to 1×10²¹ cm⁻³ The relatively higher p-type dopant concentration of the contact layer 25b, which is in direct contact with the electrode 37, leads to low contact resistance at a contact JC of the electrode 37.

The interface J1 of the contact layer 25a with the contact layer 25b tilts at an angle of larger than or equal to 50 degrees and smaller than 130 degrees with respect to the plane Sc orthogonal to the reference axis Cx that extends along the c-axis thereof. The contact layer 25b has a thickness in the range of 1 to 50 nm. For example, the contact layer 25b may have a thickness in the range of 1 to 20 nm. The bandgap of the contact layer 25a is smaller than that of the p-type cladding layer 23.

In the group-III nitride semiconductor device 11 that has the structure described above, the contact layer 25b has a relatively high p-type dopant concentration, which can cause a reduction in the contact resistance with the electrode 37, and the contact layer 25b has a relatively smaller thickness, which can provide relatively high crystallinity. The contact layer 25a has a relatively low p-type dopant concentration, which can make the crystallinity relatively higher and make the carrier concentration relatively higher. Thus, the contact resistance between the contact layer 25b and the electrode 37, and the carrier concentration are improved without reducing the crystallinity. Compared with the interface J1 between the contact layer 25a and the contact layer 25b that tilts at an angle of smaller than 50 degrees and larger than or equal to 130 degrees, the direction of the piezoelectric field is opposite thereto (the direction of the piezoelectric field component acting in the direction (direction of VN) of the layer stack is opposite to the stacking direction) and the amplitude of the piezoelectric field is relatively small or equal to zero. Thus, the external quantum efficiency and other properties of the light emitting layer 17 are improved compared with those at an angle of smaller than 50 degrees and larger than or equal to 130 degrees.

The group-III nitride semiconductor device 11 includes the substrate 13, which is composed of a gallium nitride-based semiconductor. Gallium nitride-based semiconductor layers, such as the n-type group-III nitride semiconductor region 15, the light emitting layer 17, and the p-type group-III nitride semiconductor region 19, are arranged in sequence on the primary surface 13a of the substrate 13. The primary surface 13a tilts from the plane Sc orthogonal to the reference axis Cx at an angle of larger than or equal to 50 degrees and smaller than 130 degrees. Since the substrate 13 of a gallium nitride-based semiconductor can be used, the gallium nitride-based semiconductor layers, such as the p-type group-III nitride semiconductor region 19, is grown over the primary surface 13a which tilts at an angle of larger than or equal to 50 degrees and smaller than 130 degrees from the plane Sc orthogonal to the reference axis Cx, so that the interface J1 between the contact layer 25a and the contact layer 25b also forms a tilt angle the same as that of the primary surface 13a.

The contact layer 25a and the contact layer 25b may be composed of the same gallium nitride-based semiconductor, which is a p-type InₓAl_{y}Ga_{1-x-y}N (0≤x<1, 0≤y≤1, 0≤1-x-y). Accordingly, the contact layer 25a and the contact layer 25b may be also composed of a gallium nitride-based semiconductor other than GaN.

The group-III nitride semiconductor device 11 further includes an electrode 37 and an insulating layer 39. The electrode 37 (for example, anode) and the insulating layer 39 that covers the contact layer 25b are provided on the substrate 13, the n-type group-III nitride semiconductor region 15, the light emitting layer 17, and the p-type group-III nitride semiconductor region 19. The electrode 37 is provided over the contact layer 25b and is in direct contact with the contact layer 25b through an opening 39a of the insulating layer 39. The contact layer 25b and the electrode 37 are in contact with each other at the contact JC through the opening 39a. The electrode 37 is composed of, for example, Pd, Au, or a Ni/Au (Ni and Au). The electrode 37, which is composed of such material, establishes excellent contact with the contact layer 25b. The group-III nitride semiconductor device 11 includes an electrode 41 (for example, cathode). The electrode 41 is provided on the back surface 13b of the substrate 13 and is in direct contact with the back surface 13b. The electrode 41 is composed of, for example, Pd or Ti/Al.

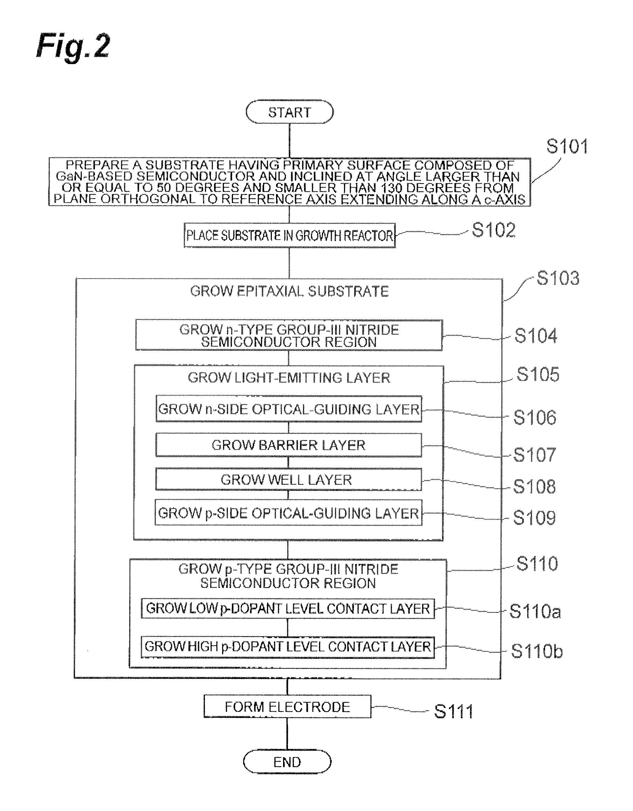

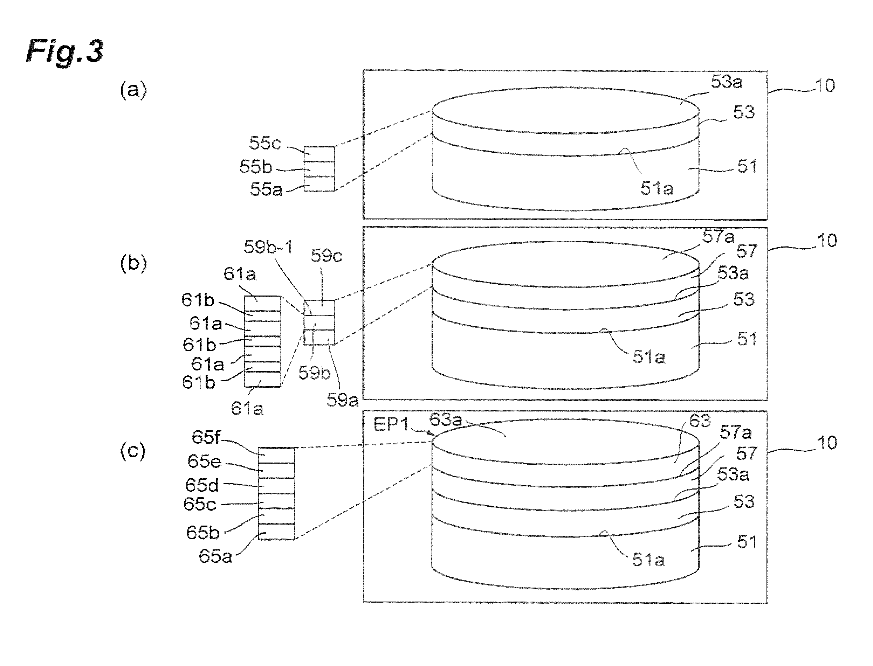

As illustrated in Part (b) of Fig. 1, the epitaxial substrate EP of the group-III nitride semiconductor device 11 includes semiconductor layers (semiconductor films) corresponding to the semiconductor layers of the group-III nitride semiconductor device 11. The above description can be applied to the corresponding semiconductor layers as well. The surface roughness of the epitaxial substrate EP has an arithmetic average roughness of 1 nm or less in a 10-µm square. Fig. 2 illustrates the primary steps in the production of the group-III nitride semiconductor device according to this embodiment. Fig. 3 is a schematic view of the products resulting from the primary steps in the production of the group-III nitride semiconductor device according to this embodiment.

The group-III nitride semiconductor device 11 and the epitaxial substrate EP that has a structure of a light emitting device are fabricated by an organic chemical vapor deposition method through the fabrication flowchart illustrated in Fig. 2. The following materials are used for epitaxial growth: trimethylgallium (TMG), trimethylindium (TMI), trimethylaluminium (TMA), ammonium (NH₃), silane (SiH₄), and Bis(cyclopentadienyl)magnesium (Cp₂Mg).

In Step S101, a substrate is prepared, which has a primary surface composed of a gallium nitride-based semiconductor (substrate 51 illustrated in Part (a) of Fig. 3). The axis normal to the primary surface 51a (corresponding to the primary surface 13 a) of the substrate 51 (corresponding to the substrate 13) tilts from the c-axis of the gallium nitride-based semiconductor at an angle of larger than or equal to 50 degrees and smaller than 130 degrees. The primary surface 51a of the substrate 51 is, for example, a hexagonal GaN (20-21) plane tilting at an angle of 75 degrees with respect to the c-plane toward the m-axis thereof. The primary surface 51a is mirror-polished.

Semiconductor layers are epitaxially grown over the substrate 51 under the following conditions. First, in Step S102, the substrate 51 is loaded into a growth reactor 10. A quartz tool, such as a quartz flow channel, is installed in the growth reactor 10. If necessary, the substrate 51 is annealed for approximately 10 minutes while thermal processing gas containing NH₃ and H₂ is supplied to the growth reactor 10 at approximately 1050 degrees Celsius and under the reactor pressure of approximately 27 kPa. Such annealing causes the modification of the primary surface 51a.

After the annealing, in Step S103, a group-III gallium nitride semiconductor layer is grown on the substrate 51 to form the epitaxial substrate EP. The atmosphere gas contains carrier gas and subflow gas. The atmosphere gas contains, for example, nitrogen and/or hydrogen. Step S103 includes the steps S104, S105, and S110 as below.

In Step S104, raw material gas containing n-type dopant and raw materials for group-III elements and group-V element, and atmosphere gas are supplied to the growth reactor 10 to epitaxially grow an n-type group-III nitride semiconductor region 53 (corresponding to the n-type group-III nitride semiconductor region 15). The tilting angle of the primary surface 53a of the n-type group-III nitride semiconductor region 53 is associated with that of the primary surface 51a of the substrate 51. The n-type group-III nitride semiconductor region 53 may include one or more group-III nitride semiconductor layers. In this embodiment, one example of the growth of the group-III nitride semiconductor layers is as follows. At a temperature of approximately 950 degrees Celsius, TMG, NH₃, SiH₄, and nitrogen and/or hydrogen are supplied to the growth reactor 10 to grow a Si-doped GaN layer 55a. Then, at a substrate temperature of approximately 870 degrees Celsius, TMG, TMI, TMA, NH₃, SiH₄, and nitrogen are supplied to the growth reactor 10 to grow a Si-doped InAlGaN layer 55b. Then, at approximately 1050 degrees Celsius, TMG, NH₃, SiH₄, and nitrogen and/or hydrogen are supplied to the growth reactor 10 to grow a Si-doped GaN layer 55c. A reducing hydrogen atmosphere allows oxygen to easily desorb from the tool and extraneous matters on the tool in the growth reactor 10.

In Step S105, a light emitting layer 57 (corresponding to the light emitting layer 17) is grown. Step S105 includes the steps S 106 to S109. In Step S106, TMG, TMI, NH₃, and nitrogen are supplied to the growth reactor 10 at a substrate temperature of approximately 840 degrees Celsius to grow an n-side InGaN optical guiding layer 59a. A part or whole of the InGaN optical guiding layer 59a may be undoped or doped with dopant of n-type conductivity.

Then, in Steps S107 and S108, an active layer 59b (corresponding to the active layer 27) is grown thereon. In Step S107, TMG, TMI, NH₃, and nitrogen atmosphere gas are supplied to the growth reactor 10 to grow an undoped InGaN barrier layer 61a. The undoped InGaN barrier layer 61a has a thickness of approximately 15 nm. After growing the undoped InGaN barrier layer 61a, growth is interrupted to change the substrate temperature from the barrier-layer growth temperature to a well-layer growth temperature. In Step S108, after the substrate temperature has been changed, TMG, TMI, NH₃, and nitrogen atmosphere gas are supplied to the growth reactor 10 to grow an undoped InGaN well layer 61b. The undoped InGaN well layer 61b has a thickness of approximately 3 nm. If necessary, the procedures for barrier layer growth, temperature change, and well layer growth may be repeated. In this embodiment, the active layer 59b has a quantum well structure of three undoped InGaN well layers 61b.

In Step S109, TMG, TMI, NH₃, and nitrogen atmosphere gas are supplied to the growth reactor 10 at a substrate temperature of approximately 840 degrees Celsius to grow a p-side InGaN optical guiding layer 59c. A part and the whole of the p-side InGaN optical guiding layer 59c may be undoped or doped with dopant for p-type conductivity. The tilt angles of the primary surface 57a of the light emitting layer 57 and the primary surface 59b-1 of the active layer 59b are associated with the tilt angle of the primary surface 51a of the substrate 51.

In Step S 110, material gas containing a group-III element source, a group-V element source and a p-type dopant, and atmosphere gas are supplied to the growth reactor 10 to epitaxially grow a p-type group-III nitride semiconductor region 63 (corresponding to the p-type group-III nitride semiconductor region 19). The tilt angle of the primary surface 63 a of the p-type group-III nitride semiconductor region 63 is associated with the tilt angle of the primary surface 51a of the substrate 51. The p-type group-III nitride semiconductor region 63 may include one or more group-III nitride semiconductor layers. In this embodiment, the following group-III nitride semiconductor layers are grown; for example, after the light emitting layer 57 has been grown, the TMG supply is stopped and the substrate temperature is increased. TMG, NH₃, Cp₂Mg, and atmosphere gas are supplied to the growth reactor 10 to grow a p-type GaN electron-blocking layer 65a at a substrate temperature of approximately 900 degrees Celsius. It is desirable to supply nitrogen atmosphere gas for the growth of the p-type GaN electron-blocking layer 65a. Then, TMG, TMI, NH₃, Cp₂Mg, and nitrogen are supplied to the growth reactor 10 to grow a Mg-doped InGaN optical guiding layer 65b at a substrate temperature of approximately 840 degrees Celsius. Then, TMG, NH₃, Cp₂Mg, and atmosphere gas are supplied to the growth reactor 10 at a temperature of approximately 900 degrees Celsius to grow a Mg-doped GaN optical guiding layer 65c. It is desirable to supply nitrogen atmosphere gas for the growth of the Mg-doped GaN optical guiding layer 65c. Then, TMG, TMI, TMA, NH₃, Cp₂Mg, and nitrogen are supplied to the growth reactor 10 at a substrate temperature of approximately 870 degrees Celsius to grow a Mg-doped InAlGaN cladding layer 65d (corresponding to the p-type cladding layer 23).

After the Mg-doped InAlGaN cladding layer 65d has been grown, a lightly Mg-doped GaN contact layer 65e (corresponding to the contact layer 25a) and a highly Mg-doped GaN contact layer 65f (corresponding to the contact layer 25b) are grown. First, in Step S110a, TMG, NH₃, Cp₂Mg, and atmosphere gas are supplied to the growth reactor 10 at a temperature of approximately 900 degrees Celsius to grow the lightly Mg-doped GaN contact layer 65e. The lightly Mg-doped GaN contact layer 65e has a thickness of approximately 40 nm. The Mg concentration of the lightly Mg-doped GaN contact layer 65e is approximately 1×10¹⁹ cm⁻³. Then the growth of the lightly Mg-doped GaN contact layer 65e is completed, and after changing the amount of the p-type dopant (Mg) supplied in the growth of the lightly Mg-doped GaN contact layer 65e (Step S110a) (for example, the amount of the p-type dopant (Mg) is changed from 1 sccm to 500 sccm, and the growth rates of the lightly Mg-doped GaN layer and the highly Mg-doped GaN layer can be also changed to achieve a designed Mg concentration, where the flow-rate controlling tool has a limitation to the control range thereof), TMG, NH₃, Cp₂Mg, and atmosphere gas is supplied to the growth reactor to grow a highly Mg-doped GaN contact layer 65f in Step S110b 10 at a temperature of approximately 900 degrees Celsius. The highly Mg-doped GaN contact layer 65f has a thickness of approximately 10 nm. The Mg concentration of the highly Mg-doped GaN contact layer 65f is approximately 5×10²⁰ cm⁻³.

The lightly Mg-doped GaN contact layer 65e and the highly Mg-doped GaN contact layer 65f are composed of the same p-type gallium nitride-based semiconductor, such as InₓAl_{y}Ga_{1-x-y}N (0≤x≤1, 0≤y≤1, 0≤1-x-y), and in particular, GaN. The amount of Mg supplied in the growth of the highly Mg-doped GaN contact layer 65f is higher than the mount of Mg supplied in the growth of the lightly Mg-doped GaN contact layer 65e. Thus, the p-type dopant (Mg) concentration of the highly Mg-doped GaN contact layer 65f is larger than that of the lightly Mg-doped GaN contact layer 65e. It is desirable to supply nitrogen atmosphere gas for the growth of the lightly Mg-doped GaN contact layer 65e and the highly Mg-doped GaN contact layer 65f. The lightly Mg-doped GaN contact layer 65e and the highly Mg-doped GaN contact layer 65f form an interface (corresponding to the interface J1).

The growth temperature of the lightly Mg-doped GaN contact layer 65e and highly Mg-doped GaN contact layer 65f may be as high as approximately 1000 degrees Celsius. The growth temperature of the lightly Mg-doped GaN contact layer 65e and highly Mg-doped GaN contact layer 65f is higher than the growth temperature of the active layer 59b. The difference between the growth temperature of the lightly Mg-doped GaN contact layer 65e and highly Mg-doped GaN contact layer 65f and the growth temperature of the active layer 59b is in the range of 100 degrees Celsius to 350 degrees Celsius or, for example, preferably in the range of 150 degrees Celsius to 300 degrees Celsius. When the growth temperature difference is smaller than this temperature difference range, the limitation in the growth temperature difference range makes the growth temperature of the lightly Mg-doped GaN contact layer 65e and highly Mg-doped GaN contact layer 65f low, thereby degrading the electrical properties. But when the growth temperature difference is greater than the above temperature difference range, the amount of thermal damage that the active layer 59b receives is increased, thereby deteriorating the light emitting efficiency. Upon completion of Steps S101 to S110 described above, an epitaxial substrate EP1 has been fabricated.

In Step S111, an electrode is formed on the epitaxial substrate EP1 (over the highly Mg-doped GaN contact layer 65f, in particular). The electrode is formed as follows: for example, a metal electrode (corresponding to the electrode 37) composed of, for example, Ni/Au or Pd is formed over the highly Mg-doped GaN contact layer 65f and a metal electrode (corresponding to the electrode 41) composed of, for example, Ti/Al is formed on the back side of the epitaxial substrate EP1. Before such formation of the electrodes, a ridge may be formed in the epitaxial substrate EP1. In Step S111, the epitaxial substrate EP is formed thereon. Then, the epitaxial substrate EP is cleaved into laser bars and a reflective film composed of a dielectric multilayer (for example, SiO₂/TiO₂) is formed on edge surfaces for the optical cavity of each laser bar, and then the laser bars are separated into the group-III nitride semiconductor device 11.

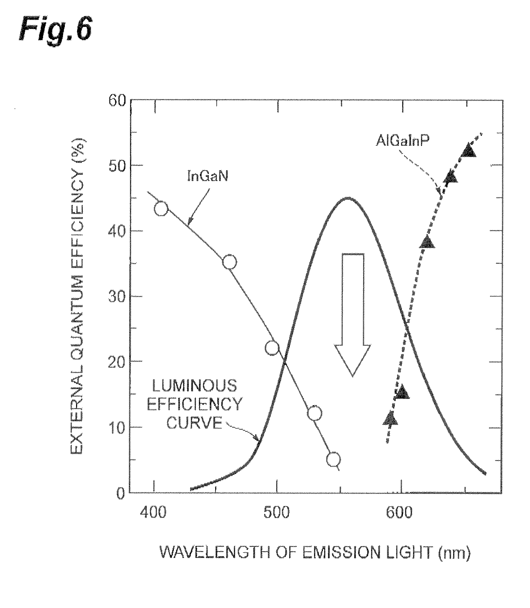

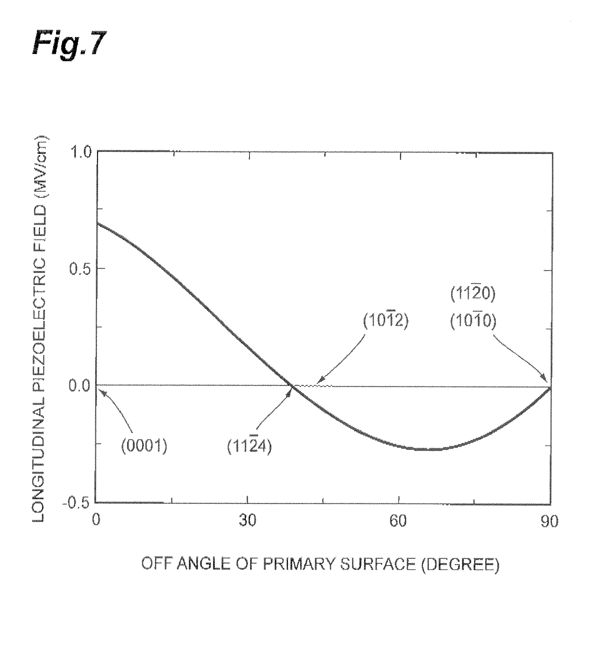

An improvement in the quality of the light emitting layer is essential for providing the light emitting device of the gallium nitride-based semiconductor with a longer emission wavelength. The quality of the light emitting layer is affected by the piezoelectric field and the inhomogeneity of the composition of InGaN in the light emitting layer. The composition inhomogeneity of the InGaN results from segregation of In in the crystal to form a high-In-composition crystal region and a low-In-composition crystal region therein and incorporate strain in the crystal. Such inhomogeneity leads to the creation of crystal defects, lowering the light emitting efficiency. First, the reference to Fig. 6 is made. Fig. 6 illustrates the external quantum efficiency of the light emitting device of the InGaN well layer, the external quantum efficiency of the AlGaInP well layer, and the luminous efficiency curve of the human eye. The transverse axis in Fig. 6 represents the wavelength (nm) of the light from the light emitting device, and the vertical axis in Fig. 6 represents the external quantum efficiency (%). As illustrated in Fig. 6, the external quantum efficiency of the light emitting device of the InGaN well layer and the external quantum efficiency of the light emitting device of the AlGaInP well layer are relatively low in the wavelength range of 480 to 600 nm in which the luminous efficiency is relatively high. Next, the reference to Fig. 7 is made. Fig. 7 illustrates the calculation results shown in Non Patent literatures 1 and 2. The transverse axis in Fig. 7 represents the off angle (degree) of the primary surface of the GaN layer, and the vertical axis in Fig. 7 represents the longitudinal piezoelectric field (MV/cm) generated inside the GaN layer. The longitudinal piezoelectric field is a component of the piezoelectric field acting in the stacking direction (VN direction) among all piezoelectric field components. As illustrated in Fig. 7, when a semi-polar or non-polar primary surface of the gallium nitride-based semiconductor substrate on which gallium nitride-based semiconductor epitaxial layers, such as a light emitting layer and contact layers, are mounted has an off angle larger than or equal to 50 degrees and smaller than 130 degrees, the longitudinal piezoelectric field has zero or a relatively small value and is opposite to the longitudinal piezoelectric field in the case of the c-plane primary surface of the substrate. Thus, when the off angle of the primary surface of the substrate is larger than or equal to 50 degrees and smaller than 130 degrees, high external quantum efficiency of the light emitting device is achieved by the longitudinal piezoelectric field of zero or a small value and of the opposite direction with respect to the piezoelectric field in the case of the c-plane primary surface of the substrate. A crystal surface having an off angle larger than or equal to 63 degrees and smaller than 80 degrees can provide a homogeneous In content in the light emitting layer in which In segregation is suppressed, thereby achieving high external quantum efficiency. Consequently, the quality of the light emitting layer is improved in the group-III nitride semiconductor device 11 according to this embodiment.

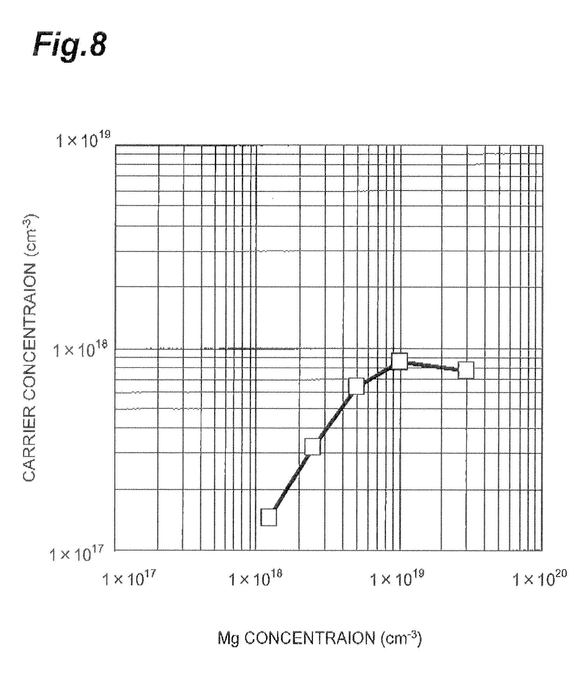

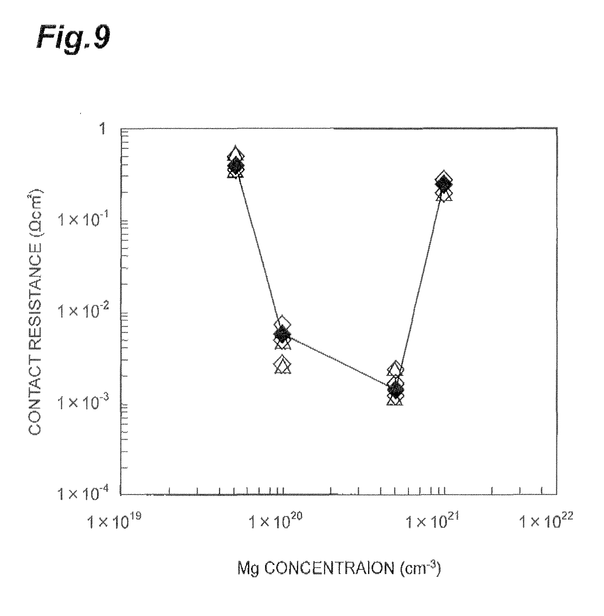

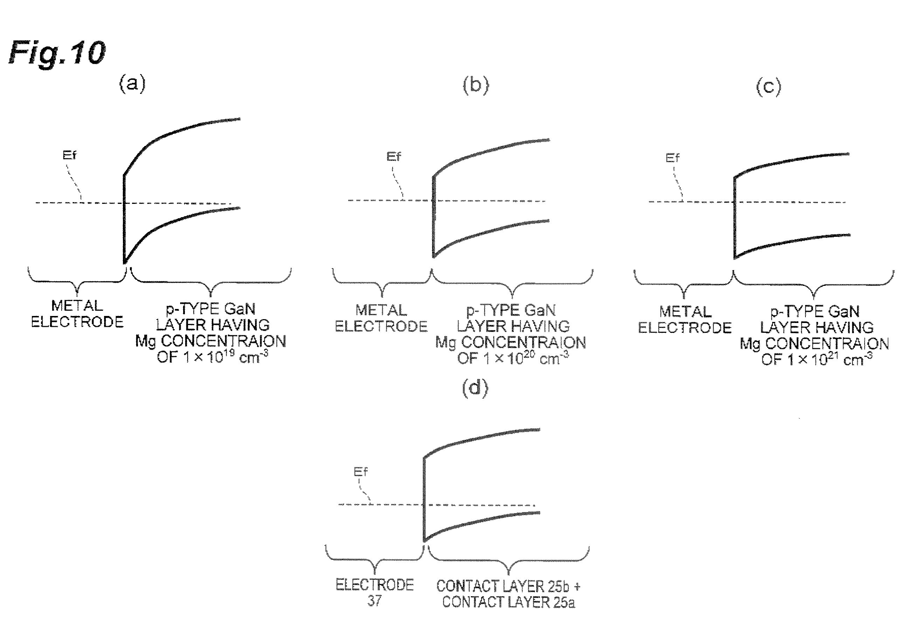

Fig. 8 illustrates the relationship between the Mg concentration and the carrier concentration in the p-type GaN layer. The transverse axis in Fig. 8 represents the Mg concentration (cm⁻³) in the p-type GaN layer, and the vertical axis in Fig. 8 represents the carrier concentration (cm⁻³) in the p-type GaN layer. As illustrated in Fig. 8, the carrier concentration increases as the Mg concentration increases to 1×10¹⁹ cm⁻³. The carrier concentration reaches a maximum value at a Mg concentration of 1×10¹⁹ cm⁻³. A Mg concentration exceeding 1×10¹⁹ cm⁻³ causes a decrease in crystallinity that leads to notable carrier compensation, and thus, a decrease in carrier concentration. A high Mg concentration impairs the crystallinity of the GaN layer. The carrier concentration is the highest within the range of a Mg concentration of 5×10¹⁸ to 5×10¹⁹ cm⁻³. Fig. 9 illustrates the relationship between the Mg concentration of the p-type GaN layer and the contact resistance. The transverse axis in Fig. 9 represents the Mg concentration (cm⁻³) in the p-type GaN layer, and the vertical axis in Fig. 9 illustrates the contact resistance (Ωcm²) between the p-type GaN layer and the metal electrode. As illustrated in Fig. 9, the contact resistance decreases steeply as the Mg concentration increases to 1×10²⁰ cm⁻³, and continues to decrease as the Mg concentration increases from 1×10²⁰ cm⁻³ to 1×10²¹ cm⁻³ though the change rate of the curve becomes reduced. The contact resistance steeply increases once the Mg concentration exceeds 1×10²¹ cm⁻³, Accordingly, the contact resistance is relatively small at a Mg concentration in the range of 3×10²⁰ to 5×10²⁰ cm⁻³, As illustrated in Fig. 10, a high Mg concentration lowers the barrier of the interface between the metal electrode and p-type GaN layer; however, a Mg concentration exceeding 1×10²¹ cm⁻³ causes significant impairment in crystallinity and a reduction in the carrier concentration. In this way, the relatively high Mg concentration may cause the contact resistance to increase, although a barrier of the interface between the metal electrode and p-type GaN layer is low.

Fig. 10 illustrates energy bands of the p-type GaN layer to which a metal electrode is attached. Part (a) of Fig. 10 illustrates an energy band of the p-type GaN layer in contact with a metal electrode, where the p-type GaN layer has a thickness of 50 nm and a Mg concentration of 1×10¹⁹ cm⁻³. Part (b) of Fig. 10 illustrates an energy band of the p-type GaN layer in contact with a metal electrode, where the p-type GaN layer has a thickness of 50 nm and a Mg concentration of 1×10²⁰ cm⁻³. Part (c) of Fig. 10 illustrates an energy band of the p-type GaN layer in contact with metal electrode, where the p-type GaN layer has a thickness of 50 nm and a Mg concentration of 1×10²¹ cm⁻³. In Fig. 10, reference characters Ef indicates the Fermi energy level.

As illustrated in Part (a) of Fig. 10, a relatively low Mg concentration causes an increase in the carrier concentration in the bulk of the p-type GaN layer. The curvature of the band near the interface with the metal electrode is relatively sharp, and thus the barrier is relatively high, causing an increase in the contact resistance. As illustrated in Part (c) of Fig. 10, a relatively high Mg concentration causes the curvature of the band near the interface with the metal electrode to become relatively small, and thus the barrier is relatively low. But, the carrier concentration of the bulk portion of the p-type GaN layer decreases, leading to a relatively large contact resistance. As illustrated in Part (b) of Fig. 10, the contact resistance corresponding to a Mg concentration having an intermediate value between the Mg concentration shown in Part (a) of Fig. 10 and the Mg concentration shown in Part (c) of Fig. 10 is smaller when compared with the contact resistances corresponding to Mg concentrations in Parts (a) and (c) of Fig. 10, but the crystallinity remains relatively low due to a larger thickness of 50 nm, and thus the carrier concentration is not made sufficiently high. The thickness may be reduced to avoid decreasing the crystallinity, but a simple reduction in thickness causes the bulk volume to decrease, not leading to an improvement in the carrier concentration.

As illustrated in Part (d) of Fig. 10, the contact layer 25a and the contact layer 25b of the group-III nitride semiconductor device 11 according to this embodiment can maintain the crystallinity whereas the contact resistance is lowered, whereby the carrier concentration is increased. The contact layer 25b, which is in direct contact with the electrode 37, has a relatively higher Mg concentration of approximately 5×10²⁰ cm⁻³ and a relatively small thickness of approximately 10 nm. The contact layer 25b in direct contact with the electrode 37 has its relatively higher Mg concentration and excellent crystallinity due to its relatively smaller thickness, whereby the contact layer 25b provides sufficiently low contact resistance. Further, the contact layer 25b is in direct contact with the contact layer 25a. The contact layer 25a has a relatively lower Mg concentration of approximately 1×10¹⁹ cm⁻³ but has a relatively large thickness of approximately 40 nm. The contact layer 25a has excellent crystallinity resulting from a relatively low Mg concentration, and has a high carrier concentration resulting from the excellent crystallinity and the relatively large thickness. Thus, the p-type contact layer in the group-III nitride semiconductor device 11 including the p-type contact layers 25a and 25b has a relatively low contact resistance and a relatively high carrier concentration without degrading crystallinity.

For example, zinc, which act as a p-type dopant, is used in place of Mg, and the physicality illustrated in Fig. 7 to 10 is applicable thereto, and another gallium nitride-based semiconductor, such as InₓAl_{y}Ga_{1-x-y}N (0≤x≤1, 0≤y≤1, 0<x+y≤1), can be used in place of GaN. The relationship among the dopant concentration, the crystallinity, and the carrier concentration is the same as in either case. The optimal dopant concentration changes depending on the kind of dopant elements. The two contact layers according to this embodiment, however, provide both relatively low contact resistance and a relatively high carrier concentration.

### Example 1

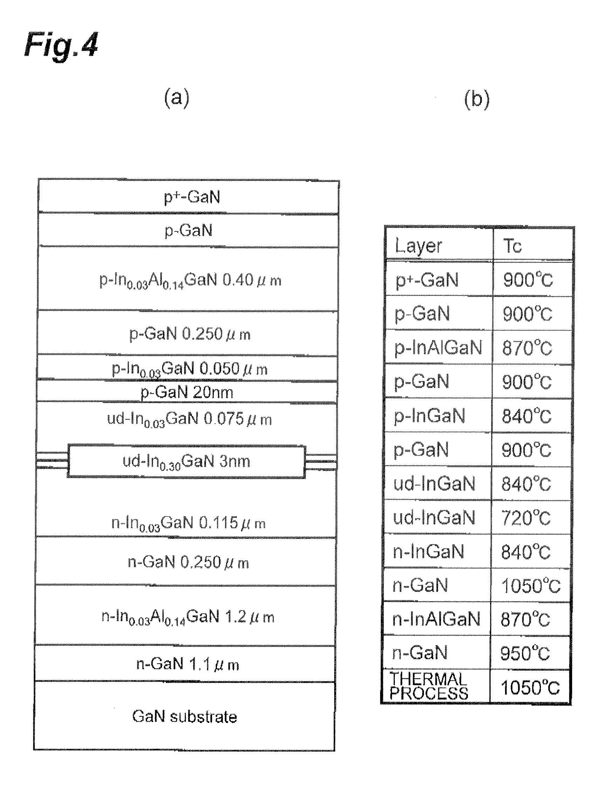

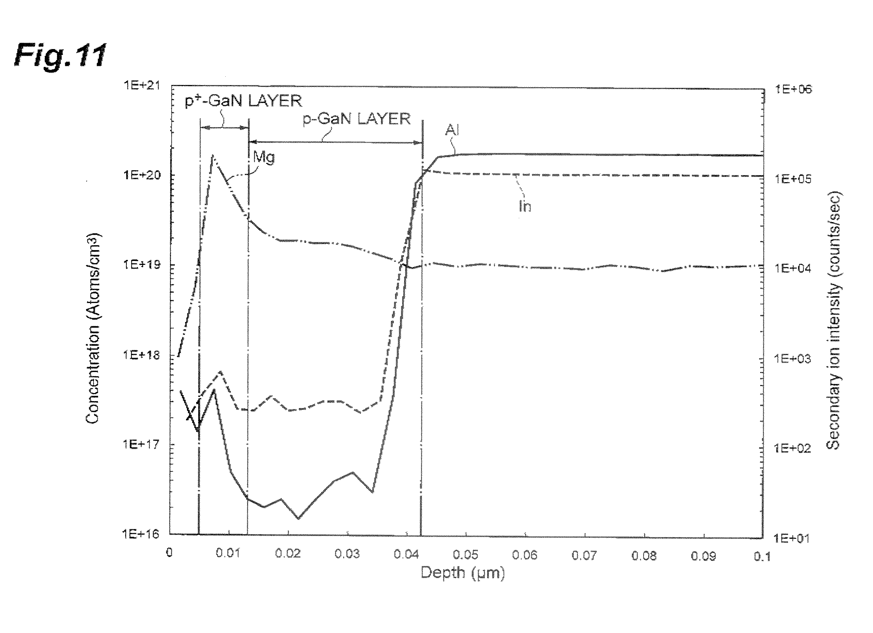

A laser diode having the device structure that is illustrated in Part (a) of Fig. 4 (corresponding to the group-III nitride semiconductor device 11) will be made below. Part (b) of Fig. 4 illustrates the growth temperature of the constituent layers of the epitaxial structure. The p-GaN layer (corresponding to the contact layer 25a) has a thickness of approximately 40 nm and a Mg concentration of approximately 1×10¹⁹ cm⁻³. The p⁺-GaN layer (corresponding to the contact layer 25b) has a thickness of approximately 10 nm and a Mg concentration of approximately 5×10²⁰ cm⁻³. The growth temperature of the p-GaN layer is the same as the growth temperature of the p⁺-GaN layer, and the relevant growth temperature is as high as approximately 900 degrees Celsius. A (20-21)-plane GaN substrate is prepared. An epitaxial layer structure is formed on the GaN substrate by a metal organic chemical vapor deposition method. Mg is used as a p-type dopant. Fig. 11 illustrates the profiles of SIMS analysis of the epitaxial structure from the surface thereof. The transverse axis in Fig. 11 represents the depth defined with respect to the surface of the epitaxial structure. In Fig. 11, the profiles for the epitaxial structure are shown in the range of the surface to a depth of approximately 100 nm. The left vertical axis in Fig. 11 represents the Mg concentration. The SIMS result in Fig. 11 indicates that the p⁺-GaN layer has a Mg concentration of approximately 2×10²⁰ cm⁻³, and the p-GaN layer has a Mg concentration of approximately 2×10¹⁹ cm⁻3 (for example, 1×10²¹ is represented by "1E+21" and 1×10⁶ is represented by "1E+06" in Fig. 11). The SIMS results shown in Fig. 11 also include the profiles of aluminum (Al) and indium (In) as markers. Referring to Fig. 11, the rising edges of the Al concentration and the In concentration correspond to the interfaces between the p-GaN layer and the underlying p-InAlGaN cladding layer. Referring back to Fig. 4, a p-type gallium nitride-based semiconductor not containing In is grown in a hydrogen atmosphere containing only hydrogen supplied as atmosphere gas. A gallium nitride-based semiconductor containing In is grown in a nitrogen atmosphere containing only nitrogen supplied as atmosphere gas. An insulating layer (for example, a SiO₂ layer) having a stripe window with a width of approximately 10 µm is formed on the epitaxial structure by wet-etching. An anode (p-side electrode) composed of Pd and a pad electrode are formed by evaporation. Then, a cathode (n-side electrode) composed of Pd and a pad electrode are formed on the back surface by evaporation. The substrate product prepared in such a manner is cleaved at approximately 600-µm intervals and is separated into laser bars. The cleaved facet is orthogonal to the (20-21) plane and the (11-20) plane. A reflective film composed of a dielectric multilayer is formed on each end facet for the optical cavity of each laser bar. The dielectric multilayer is composed of, for example, SiO₂/TiO₂. The reflectance of the front end surface is approximately 80%, whereas the reflectance of the rear end surface is approximately 95%. Lasing is observed at a wavelength of approximately 525 nm and a threshold current of approximately 3 kA/cm², where the operating voltage is approximately 6.5 volts at an optical output of 50-mW. The measured contact resistance of the anode is approximately 1×10⁻³ Ωcm².

### Example 2

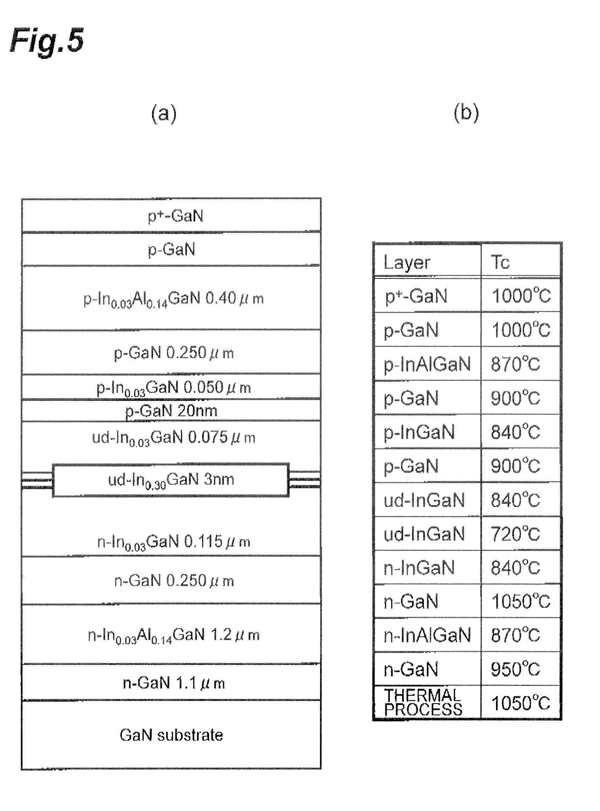

The only difference condition between Examples 1 and 2 is the growth temperature of the p-GaN layer and the p⁺-GaN layer. A laser diode having the device structure that is illustrated in Part (a) of Fig. 5 (corresponding to the group-III nitride semiconductor device 11) will be made below. Part (b) of Fig. 5 illustrates the growth temperatures of the constituent layers of the epitaxial structure. In Example 2, the p-GaN layer and the p⁺-GaN layer are grown at the same growth temperature of approximately 1000 degrees Celsius. In Example 2, the measured contact resistance of the anode is approximately 1×10⁻⁴ Ωcm², which is higher than that in Example 1. The operating voltage at an optical output of 50-mW is 5.5 volts, which is higher than that in Example 1. The device life time exceeds 10000 hours. The results of Examples 1 and 2 indicate that it is preferable to make the growth temperature of the highly Mg-doped p⁺-GaN layer high in the range that does not damage the active layer (ud-InGaN layer (3 nm)).

### Examples 3 to 5

Examples 3 to 5 comprise a single p⁺-GaN layer in place of the p-GaN layer and p⁺-GaN layer as in Examples 1 and 2. The growth temperature of the single p⁺-GaN layer in Examples 3 to 5 is approximately 900 degrees Celsius. Fabrication conditions in Examples 3 to 5 are identical to those in Examples 1 and 2, except for the layer structure of the p⁺-GaN layer and its growth temperature. In Example 3, the p⁺-GaN layer has a thickness of approximately 50 nm and a Mg concentration of approximately 1×10¹⁹ cm⁻³. The measured contact resistance of the anode is approximately 1×10⁻¹ Ωcm², and the operating voltage at an optical output of 50-mW is approximately 8.5 volts. In Example 4, the p⁺-GaN layer has a thickness of approximately 50 nm and a Mg concentration of approximately 1×10²⁰ cm⁻³, The measured contact resistance of the anode is approximately 1×10⁻² Ωcm², and the operating voltage at an optical output of 50-mW is approximately 7.5 volts. In Example 5, the p⁺-GaN layer has a thickness of approximately 50 nm and a Mg concentration of approximately 1×10²¹ cm⁻³. The measured contact resistance of the anode is approximately 1×10⁻¹ Ωcm², and the operating voltage at an optical output of 50-mW is approximately 8.5 volts. Accordingly, the contact resistance and the operating voltage of the anode in Examples 1 and 2 are improved (i.e., the values of the contact resistance and the operating voltage both are small) compared with those in Examples 3 to 5.

Having described and illustrated the principle of the invention in a preferred embodiment thereof, it is appreciated by those having skill in the art that the invention can be modified in arrangement and detail without departing from such principles. The present invention is not limited to the specific configurations described in the embodiments. We therefore claim all modifications and variations coming within the spirit and scope of the following claims.

### Other Embodiments

In the production process of the GaN-based semiconductor light emitting device that generates light in a long-wavelength range of the green band, it is especially advantageous to use a substrate having a primary surface which is semi-polar or non-polar because the piezoelectric field applied to the light emitting layer can be reduced and a high-quality InGaN light emitting layer having low In segregation can be produced, and so on.

The inventors have considered that there are at least two technical problems in using a semi-polar surface or a non-polar surface. One of the technical problems is that the contact resistance between the substrate and the p-side electrode is relatively high. Typically, the contact resistance demonstrated on a substrate having the primary surface of the c-plane is approximately 5×10⁻⁴ Ωcm², whereas the contact resistance demonstrated on the substrate having a semi-polar or non-polar primary surface is approximately 2×10⁻² Ωcm², and the latter is an increase by approximately two orders of magnitude as compared with the former. Such an increase in the contact resistance causes an increase in voltage by approximately 2 volts when a current is applied thereto in the longitudinal direction.

The other technical problem is that the InGaN light emitting layer, which emits long-wavelength light and has a high In content, is not excellent thermal tolerance, and thus the growth temperature of the p-type layer must be decreased (typically from approximately 1100 degrees Celsius to approximately 900 degrees Celsius). This decrease in temperature may deteriorate the crystal quality of the p-type layer. Such deterioration in the crystal quality of the p-type layer adversely affects the contact resistance. Typically, the contact resistance is approximately 5×10⁻³ Ωcm² on a substrate having the primary surface of the c-plane, whereas the contact resistance is approximately 5×10⁻² Ωcm² on the substrate having a primary surface of semi-polar or non-polar planes. Accordingly, the contact resistance on these planes is adversely affected, regardless of the plane orientation of the primary surface of the substrate.

The inventors have found a method of fabricating a GaN-based semiconductor light emitting device having satisfactorily low contact resistance in the p-type layer that is grown on the semi-polar or non-polar primary surface of the substrate at a low temperature. In the growth of the p-type layer for protection of the light emitting layer in a hydrogen atmosphere at a relatively low temperature (approximately 900 degrees Celsius), when the growth rate is equal to 1µm/hour or higher, carbon acting as impurity is introduced to the p-type layer by an amount of approximately 1×10¹⁸ cm⁻³ over 1×10¹⁷ cm⁻³. Such carbon impurity concentration increases the electrical resistance of the p-type layer, thereby adversely affecting the contact resistance between the p-type layer and the electrode. In contrast, the inventors have discovered that lowering the growth rate to increase the molar ratio, i.e., (the number of group-V atoms)/( the number of group-III atoms), is effective in lowering the carbon impurity concentration of the p-type layer and have succeeded in actually lowering the contact resistance. In such a case, the growth rate for a contact layer having a surface in contact with the p-side electrode and highly doped with Mg (a p⁺-GaN layer corresponding to the highly Mg-doped GaN contact layer 65f) is 0.1 µm/hour or less, and the growth rate for a contact layer in contact with the above contact layer and doped with Mg at a relatively low concentration (a p-GaN layer corresponding to the lightly Mg-doped GaN contact layer 65e) is 1 µm/hour or less.

The inventors have discovered that growing a p-type layer in a nitrogen atmosphere is also an effective in lowering the carbon impurity concentration. In this case, however, a significant improvement in the contact resistance is not observed. The inventors have analyzed the cause of such a phenomenon (i.e., a p-type layer grown in a nitrogen atmosphere may have a reduced carbon impurity concentration but not makes the contact resistance significantly improved). That is, the inventors have analyzed the cause in consideration of the fact that Mg atoms displacing Ga atoms in the GaN act as acceptors and the fact that Mg atoms efficiently displace Ga atoms in a hydrogen atmosphere but do not efficiently displace Ga atoms in a nitrogen atmosphere to enter interstitial cites. In accordance with the above-described explanation, the inventors have concluded that the above aspect (i.e., a p-type layer grown in a nitrogen atmosphere may have a lowered carbon impurity concentration but not have significantly reduced contact resistance) is caused by the phenomenon that Mg atoms doped in a nitrogen atmosphere do not work as effective acceptors, although the SIMS analysis teaches that the concentration of Mg atoms doped in the nitrogen atmosphere is approximately the same as that doped in the hydrogen atmosphere.

The inventors have discovered a GaN-based semiconductor light emitting device having satisfactorily low contact resistance and a method of fabricating the GaN-based semiconductor light emitting device that enable the growth of a p-type layer over a substrate having a semi-polar or non-polar primary surface at a low temperature under the following growth condition: at a decreased growth rate; in a hydrogen atmosphere and an increased ratio (molar ratio of supplied materials), i.e., (the number of group-V atoms)/ (the number of group-III atoms). The following modifications are applied to the structure of the epitaxial substrate EP1 illustrated in Fig. 3 and the method of fabricating the epitaxial substrate EP1, thereby achieving the method of fabricating a GaN-based semiconductor light emitting device with satisfactorily low contact resistance provided by growing the p-type layer over a substrate having a semi-polar or non-polar primary surface at a low temperature, and the GaN-based semiconductor light emitting device produced through such a method. The modified epitaxial substrate is hereinafter referred to as "epitaxial substrate EP11."

The differences (modifications) between the structure and method of production of the epitaxial substrate EP11 and those of the epitaxial substrate EP1 will be listed below: Regarding the epitaxial substrate EP11, hydrogen is used for atmosphere gas in the growth of the Si-doped GaN layer 55a, the lightly Mg-doped GaN contact layer 65e, and the highly Mg-doped GaN contact layer 65f; and regarding the epitaxial substrate EP11, nitrogen is used for atmosphere gas in the growth of other layers of the epitaxial substrate EP11. These are important items for creating the GaN-based semiconductor light emitting device having satisfactorily low contact resistance, and the method of fabricating the GaN-based semiconductor light emitting device.

Regarding the epitaxial substrate EP11, a p-type GaN electron-blocking layer 65a is not formed in the growth of the p-type group-III nitride semiconductor region 63; regarding the epitaxial substrate EP11, the growth temperature of, the Si-doped GaN layer 55c is set to approximately 840 degrees Celsius; regarding the epitaxial substrate EP11, the growth temperatures of the lightly Mg-doped GaN contact layer 65e and the highly Mg-doped GaN contact layer 65f are both set at approximately 870 degrees Celsius; and regarding the epitaxial substrate EP11, a Mg-doped AlGaN cladding layer, not a Mg-doped InAlGaN cladding layer, is provided at the position designated by reference characters 65d illustrated in the drawing. These are modifications not associated with the configuration of the GaN-based semiconductor light emitting device having satisfactorily low contact resistance, and the method of fabricating the GaN-based semiconductor light emitting device.

Except for the differences described above, the structures and method of fabricating the epitaxial substrate EP11 are the same as those of the epitaxial substrate EP1.

The carbon impurity concentration in the lightly Mg-doped GaN contact layer 65e of the epitaxial substrate EP11 is 1×10¹⁷ cm⁻³ or less. The relatively low carbon impurity concentration decreases the contact resistance and the operating voltage of the device.

The primary surface 51a of the substrate 51 in the epitaxial substrate EP11 may tilt at an angle which is larger than or equal to 70 degrees and smaller than 80 degrees from a plane (plane Sc) orthogonal to the reference axis (reference axis Cx) that extends along a c-axis of the gallium nitride-based semiconductor, or tilt at an angle which is larger than or equal to 100 degrees and smaller than 110 degrees from a plane (plane Sc) orthogonal to the reference axis (reference axis Cx) that extends along the c-axis of the gallium nitride-based semiconductor. The use of a substrate in which its primary surface tilts by such an angle range reduces the fluctuation in the In content of the light emitting layer and enables the production of a light emitting device having satisfactorily high external quantum efficiency.

In the method of fabricating the epitaxial substrate EP11, the growth rate of the lightly Mg-doped GaN contact layer 65e is 1 µm/hour or less; the growth rate of the highly Mg-doped GaN contact layer 65f is 0.1 µm/hour or less; the growth rate of the highly Mg-doped GaN contact layer 65f is lower than the growth rate of the lightly Mg-doped GaN contact layer 65e; and the lightly Mg-doped GaN contact layer 65e and the highly Mg-doped GaN contact layer 65f are grown in an atmosphere containing at least 20% hydrogen (volume percent (vol%)). Hydrogen atmosphere gas is used in the growth of the lightly Mg-doped GaN contact layer 65e and the highly Mg-doped GaN contact layer 65f, and the growth rate of the lightly Mg-doped GaN contact layer 65e and the growth rate of the highly Mg-doped GaN contact layer 65f are relatively low, so that the ratio, (the number of group-V atoms)/( the number of group-III atoms), can be relatively large in the growth of the lightly Mg-doped GaN contact layer 65e and the highly Mg-doped GaN contact layer 65f. Thus, the carbon impurity concentrations of the lightly Mg-doped GaN contact layer 65e and the highly Mg-doped GaN contact layer 65f can be made relatively low, providing satisfactorily low contact resistance to the electrode and excellent operating voltage of the device. In order to reduce the carbon impurity concentration of the lightly Mg-doped GaN contact layer 65e and the highly Mg-doped GaN contact layer 65f, the lightly Mg-doped GaN contact layer 65e and the highly Mg-doped GaN contact layer 65f can be grown in a nitrogen atmosphere, but, since it is difficult to grow crystal highly doped with Mg in a nitrogen atmosphere, the crystallinity of the lightly Mg-doped GaN contact layer 65e and the highly Mg-doped GaN contact layer 65f is not made excellent, causing an increase in the contact resistance to the electrode and the operating voltage of the device. In order to reduce the carbon impurity concentration of the lightly Mg-doped GaN contact layer 65e and the highly Mg-doped GaN contact layer 65f, the growth temperatures of the lightly Mg-doped GaN contact layer 65e and the highly Mg-doped GaN contact layer 65f can be increased, but, since the growth temperature of the active layer is made low for emission of relatively long wavelength light and its thermal tolerance to the subsequent growth of the p-layer is reduced, the active layer 59b may be damaged. Decreasing the growth rate in a hydrogen atmosphere and increasing the ratio of (the number of the group-V atoms)/( the number of group-III atoms) allow the production of a GaN-based semiconductor light emitting device having satisfactorily low contact resistance on a substrate of a semi-polar or non-polar primary surface, even if the p-type layer is grown at a low temperature for protection of the light emitting layer emitting light having a relatively long wavelength.

In the method of fabricating the epitaxial substrate EP11, the growth temperature of the active layer 59b is higher than or equal to 650 degrees Celsius and lower than 800 degrees Celsius. In the method of fabricating the epitaxial substrate EP11, the difference between the growth temperature of the active layer 59b and the growth temperature of the lightly Mg-doped GaN contact layer 65e and highly Mg-doped GaN contact layer 65f is within the range of 100 degrees Celsius to 250 degrees Celsius. Such a temperature range can reduce the damage applied to the active layer 59b during the growth of the p-type layer.

### Example 6

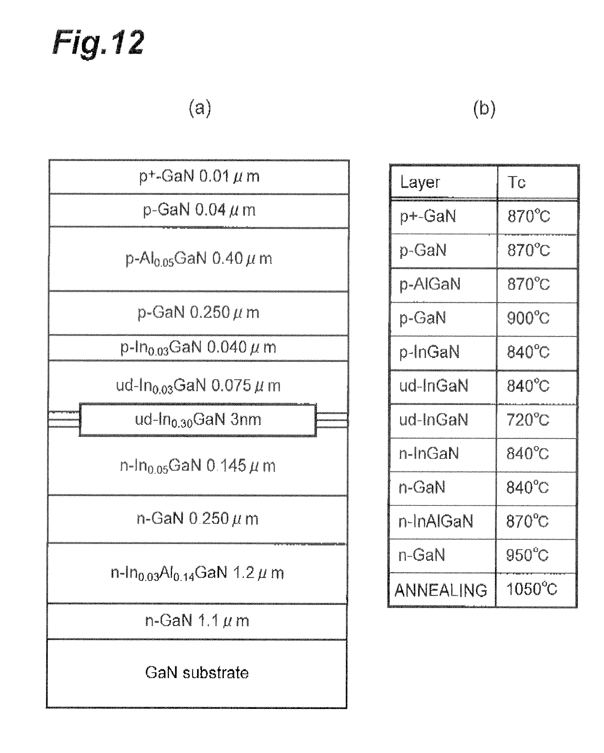

An epitaxial substrate EP11 according to Example 6 will now be described. Example 6 describes a laser diode having the device structure illustrated in Part (a) of Fig. 12. Part (b) of Fig. 12 illustrates the growth temperature of the epitaxial layers for the device structure illustrated in Part (a) of Fig. 12.

With reference to Figs. 4 and 12, Example 6 is the same as Example 1 except for the points described below. Example 6 and Example 1 have the following seven differences: Hydrogen is used as atmosphere gas during the growth of the n-GaN layer corresponding to the Si-doped GaN layer 55a, the p-GaN layer corresponding to the low-level Mg-doped GaN contact layer 65e, and the p⁺-GaN layer corresponding to the high-level Mg-doped GaN contact layer 65f;

Nitrogen is used as atmosphere gas during the growth of other layers; and

The growth rate of the p-GaN layer corresponding to the lightly Mg-doped GaN contact layer 65e is set at 0.43 µm/hour, and the growth rate of the p⁺-GaN layer corresponding to the highly Mg-doped GaN contact layer 65f is set at 0.07 µm/hour. These differences are important factors in the GaN-based semiconductor light emitting device having satisfactorily low contact resistance and the method of fabricating such a GaN-based semiconductor light emitting device.

The other differences are as follows:

The growth temperature of the p-GaN layer corresponding to the lightly Mg-doped GaN contact layer 65e and the growth temperature of the p⁺-GaN layer corresponding to the highly Mg-doped GaN contact layer 65f are both set at approximately 870 degrees Celsius;

The n-InGaN layer corresponding to the InGaN optical guiding layer 59a has a thickness of approximately 0.145 µm and an indium (In) content of approximately 0.05;

Instead of a p-GaN layer corresponding to the p-type GaN electron-blocking layer 65a, a p-InGaN layer corresponding to the Mg-doped InGaN optical guiding layer 65b and having a thickness of approximately 0.040 µm is grown over the ud-InGaN layer corresponding to the p-side InGaN optical guiding layer 59c; and Instead of an InAlGaN layer corresponding to the Mg-doped InAlGaN cladding layer 65d, the p-AlGaN layer having a thickness of approximately 0.40 µm and an Al content of 0.05 is provided between the p-GaN layer corresponding to the Mg-doped GaN optical guiding layer 65c and the p-GaN layer corresponding to the lightly Mg-doped GaN contact layer 65e.

These differences are not associated with satisfactorily low contact resistance of the GaN-based semiconductor light emitting device and the method of fabricating such a GaN-based semiconductor light emitting device.

In Example 6, lasing is observed at a wavelength of approximately 525 nm and a threshold current of approximately 3 kA/cm², where the operating voltage of a 50-mW optical output is approximately 5.5 volts. In Example 6, the contact resistance between the p⁺-GaN layer corresponding to the highly Mg-doped GaN contact layer 65f and the metal electrode (palladium (Pd) electrode) is measured using a transmission line method (TLM). The contact resistance between the p⁺-GaN layer and the metal electrode (Pd electrode) measured by the TLM is smaller than or equal to 5×10⁻⁴ Ωcm² on the entire surface of the p⁺-GraN layer.

In Example 6, the growth temperature of the p-GaN layer corresponding to the lightly Mg-doped GaN contact layer 65e and the growth temperature of the p⁺-GaN layer corresponding to the highly Mg-doped GaN contact layer 65f are both set at approximately 870 degrees Celsius, which is a relatively lower temperature (lower when compared with Examples 1 and 2). A decrease in the growth temperature of the contact layers (p-GaN layer and p⁺-GaN layer) prevents heat deterioration of the active layer during the growth of the contact layers.

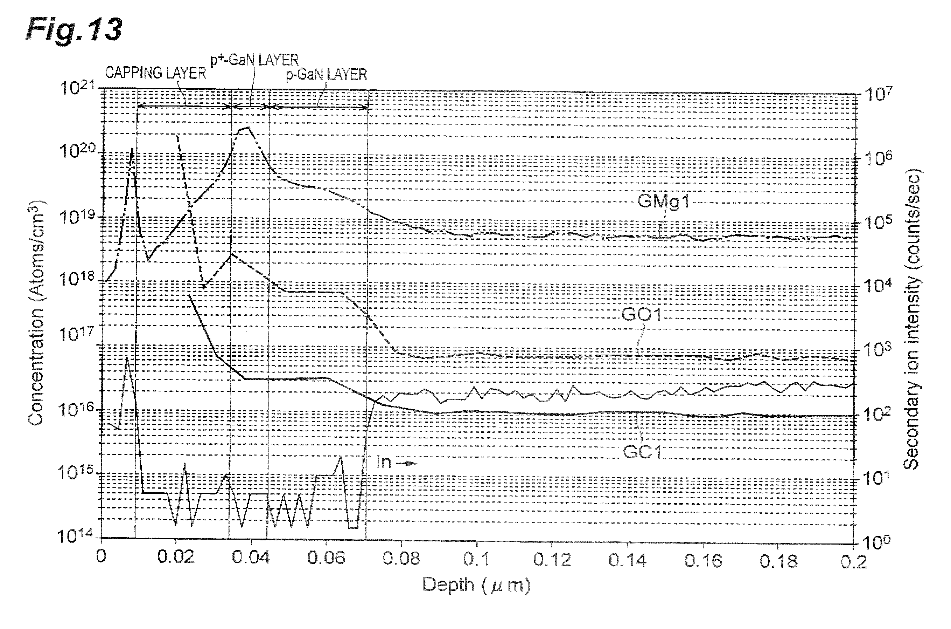

Figs. 13 to 15 illustrates the SIMS profiles of the epitaxial structure from the top surface. In the observed epitaxial structure, an undoped GaN cap layer is grown over the highly Mg-doped GaN contact layer 65f so as to accurately measure the atom concentrations in the contact layers. The transverse axis in each drawing represents the depth defined from the surface (p-side surface) of the epitaxial structure. Each drawing illustrates the SIMS profiles of the epitaxial structure in the range of the surface (p-side surface) to a depth of approximately 200 nm. The SIMS measurements in Figs. 13 to 15 also include the profiles of magnesium (Mg), aluminum (Al), and indium (In) as markers. The left vertical axis in each drawing represents the concentrations of carbon (C) and magnesium (Mg) atoms. The curves GC1, GC2, and GC3 in each drawing represent the profiles of carbon (C). The curves GMg1, GMg2, and GMg3 in each drawing represent the profiles of magnesium (Mg). Similar to Example 6, Fig. 13 illustrates the measurement of an epitaxial structure formed by growing the p-GaN layer (corresponding to the low-concentration Mg-doped GaN contact layer 65e) and the p⁺-GaN layer (corresponding to the highly Mg-doped GaN contact layer 65f) in a hydrogen atmosphere gas, the growth rate of the p-GaN layer (corresponding to the lightly Mg-doped GaN contact layer 65e) being set at approximately 0.43 µm/hour, and the growth rate of the p⁺-GaN layer (corresponding to the highly Mg-doped GaN contact layer 65f) being set at approximately 0.07 µm/hour. In this case, the contact resistance between the p-side surface and Pd electrode of the epitaxial structure is approximately 5×10⁻⁴ Ωcm². The carbon (C) concentration represented by the curve GC1 is approximately 3×10¹⁶ cm⁻³ in the p-GaN layer (corresponding to the lightly Mg-doped GaN contact layer 65e) and approximately 3×10¹⁶ cm⁻³ in the p⁺-GaN layer (corresponding to the highly Mg-doped GaN contact layer 65f). The oxygen (O) concentration represented by the curve GO1 is approximately 7×10¹⁷ cm⁻³ in the p-GaN layer (corresponding to the lightly Mg-doped GaN contact layer 65e) and approximately 7×10¹⁷ cm⁻³ in the p⁺-GaN layer (corresponding to the highly Mg-doped GaN contact layer 65f). The magnesium (Mg) concentration represented by the curve GMg1 is approximately 3×10¹⁹ cm⁻³ in the p-GaN layer (corresponding to the lightly Mg-doped GaN contact layer 65e) and approximately 3×10²⁰ cm⁻³ in the p⁺-GaN layer (corresponding to the highly Mg-doped GaN contact layer 65f).

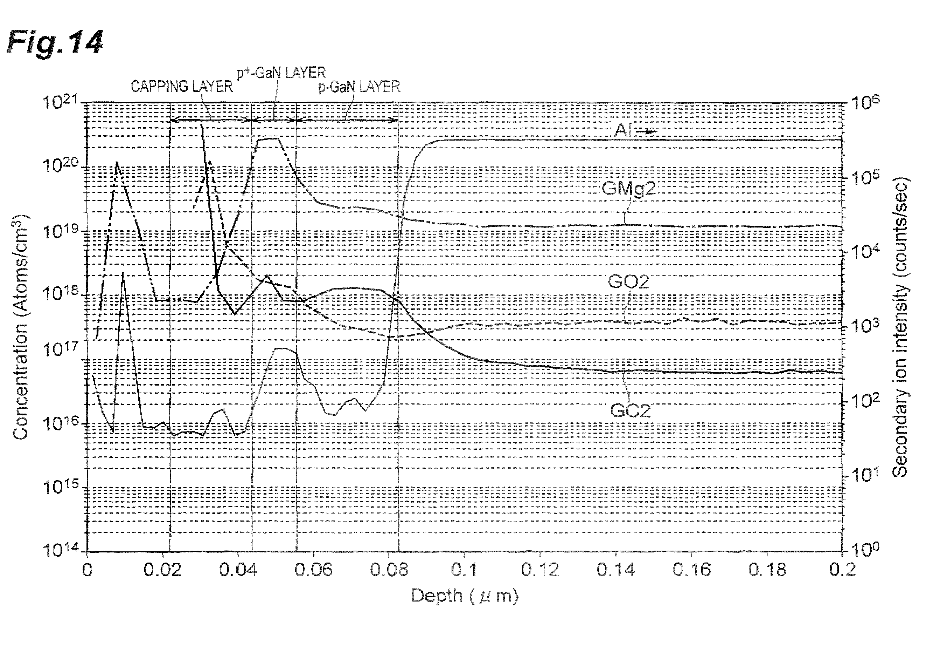

Fig 14 illustrates the measurement of an epitaxial structure formed by growing the p-GaN layer (corresponding to the lightly Mg-doped GaN contact layer 65e) and the p⁺-GaN layer (corresponding to the highly Mg-doped GaN contact layer 65f) in a hydrogen atmosphere gas, the growth rate of the p-GaN layer (corresponding to the lightly Mg-doped GaN contact layer 65e) being set at a higher growth rate (which is approximately 3.5 µm/hour, and approximately 0.21 µm/hour for the p⁺-GaN layer) than that represented by the curve GMg1. In this case, the contact resistance between the p-side surface and Pd electrode of the epitaxial structure is approximately 2×10⁻³ Ωcm². The carbon (C) concentration represented by the curve GC2 is approximately 1×10¹⁸ cm⁻³ in the p-GaN layer (corresponding to the lightly Mg-doped GaN contact layer 65e) and approximately 1×10¹⁸ cm⁻³ in p⁺-GaN layer (corresponding to the highly Mg-doped GaN contact layer 65f). The oxygen (O) concentration represented by the curve GO2 is approximately 3×10¹⁷ cm⁻³ in the p-GaN layer (corresponding to the lightly Mg-doped GaN contact layer 65e) and approximately 3×10¹⁷ cm⁻³ in p⁺-GaN layer (corresponding to the highly Mg-doped GaN contact layer 65f). The magnesium (Mg) concentration represented by the curve GMg2 is approximately 3×10¹⁹ cm⁻³ in the p-GaN layer (corresponding to the lightly Mg-doped GaN contact layer 65e) and approximately 3×10²⁰ cm⁻³ in p⁺-GaN layer (corresponding to the highly Mg-doped GaN contact layer 65f).

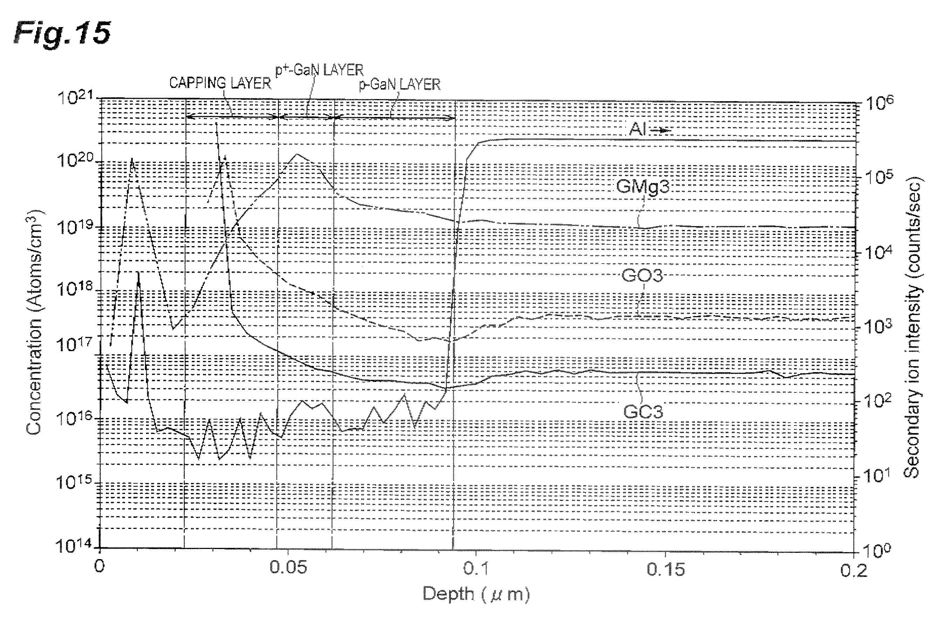

Fig. 15 illustrates the measurement of an epitaxial structure formed by growing the p-GaN layer (corresponding to the lightly Mg-doped GaN contact layer 65e) and the p⁺-GaN layer (corresponding to the highly Mg-doped GaN contact layer 65f) in nitrogen atmosphere gas, the growth rate of the p-GaN layer (corresponding to the lightly Mg-doped GaN contact layer 65e) being set at the same rate as that represented by the curve GMg1. In this case, the contact resistance between the p-side surface and Pd electrode of the epitaxial structure is approximately 2×10⁻³ Ωcm². The carbon (C) concentration represented by the curve GC3 is approximately 4×10¹⁶ cm⁻³ in the p-GaN layer (corresponding to the lightly Mg-doped GaN contact layer 65e) and approximately 4×10¹⁶ cm⁻³ in p⁺-GaN layer (corresponding to the highly Mg-doped GaN contact layer 65f). The oxygen (O) concentration represented by the curve GO3 is approximately 2×10¹⁷ cm⁻³ in the p-GaN layer (corresponding to the lightly Mg-doped GaN contact layer 65e) and approximately 2×10¹⁷ cm⁻³ in p⁺-GaN layer (corresponding to the highly Mg-doped GaN contact layer 65f). The magnesium (Mg) concentration represented by the curve GMg3 is approximately 3×10¹⁹ cm⁻³ in the p-GaN layer (corresponding to the lightly Mg-doped GaN contact layer 65e) and approximately 3×10²⁰ cm⁻³ in p⁺-GaN layer (corresponding to the highly Mg-doped GaN contact layer 65f).

The curve GC1 illustrated in Fig. 12 indicates that the carbon (C) concentration is approximately 3×10¹⁶ cm⁻³, which is relatively lower, where the contact layers (the p-GaN layer and the p⁺-GaN layer) are grown at a relatively lower rate in hydrogen atmosphere gas. In contrast, the curve GC2 indicates that the carbon (C) concentration is approximately 1×10¹⁸ cm⁻³, which is relatively higher, where the growth rate of the contact layers (the p-GaN layer and the p⁺-GaN layer) is higher than that indicated by the curve GC1, regardless of the use of hydrogen atmosphere gas. The curve GC3 indicates that the carbon (C) concentration is 4×10¹⁶ cm⁻³, which is relatively lower, and the crystallinity is relatively lower when nitrogen atmosphere gas is used for growth of the contact layers (the p-GaN layer and the p⁺-GaN layer). Furthermore, the contact resistance between the p-side surface and the Pd electrode of the epitaxial structure is approximately 5×10⁻⁴ Ωcm², which is relatively lower, where the growth rate of the contact layers (the p-GaN layer and the p⁺-GaN layer) in hydrogen atmosphere gas is made relatively low, in other words, in conditions in which the curves GC1, GO1, and GMg1 of the measurements have been provided.

### Industrial Applicability

Embodiments according to the present invention provide a method of fabricating a group-III nitride semiconductor device and a group-III nitride semiconductor device that has p-type contact layers with a relatively smaller contact resistance and a relatively higher carrier concentration without reducing the crystallinity.

### Reference Signs List

10 growth reactor;
11group-III nitride semiconductor device:
13, 55 substrate;
13a, 51a, 53a, 57a, 59b-1, 63a primary surface;
13b back surface;
15, 53 .n-type group-III nitride semiconductor region 15;
17 light emitting layer;
19, 63 p-type group-III nitride semiconductor region;
21 p-type gallium nitride-based semiconductor layer;
23 p-type cladding layer;
25a, 25b contact layer;
27 active layer;
29 n-side optical guiding layer;
31 p-side optical guiding layer;
33 well layer;
35 barrier layers;
37, 41 electrode;
39 insulating layer;
39a opening;
55a Si-doped GaN layer;
55b Si-doped InAlGaN layer;
55c Si-doped GaN layer;
59a InGaN optical guiding layer;
59c InGaN optical guiding layer;
61a undoped InGaN barrier layer;
61b undoped InGaN well layer;
65a p-type GaN electron-blocking layer;
65b Mg-doped InGaN optical guiding layer;
65c Mg-doped GaN optical guiding layer;
65d Mg-doped InAlGaN cladding layer;
65e .lightly Mg-doped GaN contact layer;
65f highly Mg-doped GaN contact layer;
Ax normal axis;
CR crystal coordinate system;
Cx reference axis;
EP, EP1, EP11 epitaxial substrate;
J1 .interface;
JC contact;
S1 coordinate system;
Sc plane;
VC c-axis vector;
VN .nomnal vector.

## Claims

1. A group-III nitride semiconductor device comprising:
a gallium nitride-based semiconductor light emitting layer;
a first contact layer provided on the light emitting layer;
a second contact layer provided on the first contact layer and in direct contact with the first contact layer; and
a metal electrode provided on the second contact layer and in direct contact with the second contact layer;
a gallium nitride-based semiconductor of the first contact layer being the same as a gallium nitride-based semiconductor of the second contact layer, the first contact layer and the second contact layer having a p-type conductivity,
a p-type dopant concentration of the first contact layer being lower than a p-type dopant concentration of the second contact layer,
an interface between the first contact layer and the second contact layer tilting at an angle of not less than 50 degrees and smaller than 130 degrees from a plane orthogonal to a reference axis, the reference axis extending along a c-axis thereof,
a wavelength of light emitted from the light emitting layer being in a range of 480 to 600 nm, and
the second contact layer having a thickness in a range of 1 to 50 nm.

2. The group-III nitride semiconductor device according to Claim 1, wherein the second contact layer has a thickness in a range of 1 to 20 nm.

3. The group-III nitride semiconductor device according to Claim 1 or 2, comprising a cladding layer of a p-type gallium nitride-based semiconductor,
wherein
the cladding layer is provided between the light emitting layer and the first contact layer,
a bandgap of the cladding layer is larger than a bandgap of the first contact layer, and
the first contact layer is in direct contact with the cladding layer.

4. The group-III nitride semiconductor device according to Claim 3, further comprising a substrate, the substrate comprising a gallium nitride-based semiconductor,
wherein
the light emitting layer, the cladding layer, the first contact layer, the second contact layer, and the metal electrode are arranged in sequence on a primary surface of the substrate, and
the primary surface tilts at an angle of not less than 50 degrees and smaller than 130 degrees from a plane orthogonal to the reference axis.

5. The group-III nitride semiconductor device according to any one of Claims 1 to 4, wherein a p-type dopant concentration of the first contact layer is not more than 5×10²⁰ cm⁻³.

6. The group-III nitride semiconductor device according to any one of Claims 1 to 5, wherein a p-type dopant concentration of the second contact layer is in a range of 1×10²⁰ to 1×0²¹ cm⁻³.

7. The group-III nitride semiconductor device according to any one of Claims 1 to 6, wherein a p-type dopant concentration of the first contact layer is in a range of 5×10¹⁸ to 5×10¹⁹ cm⁻³.

8. The group-III nitride semiconductor device according to any one of Claims 5 to 7, wherein the p-type dopant comprises magnesium.

9. The group-III nitride semiconductor device according to any one of Claims 1 to 8, wherein the first contact layer comprises gallium nitride and the second contact layer comprise gallium nitride.

10. The group-III nitride semiconductor device according to any one of Claims 1 to 8, wherein the first contact layer and the second contact layer comprise InₓAl_{y}Ga_{1-x-y}N (0≤x≤1, 0≤y≤1, 0≤1-x-y).

11. The group-III nitride semiconductor device according to any one of Claims 1 to 10, wherein the light emitting layer comprises InₓGa₁₋ₓN (0.15≤x<0.50).

12. The group-III nitride semiconductor device according to any one of Claims 1 to 11, wherein the metal electrode comprises one of palladium, gold, and nickel and gold.

13. A method of fabricating a group-III nitride semiconductor device, comprising the steps of:
growing a light emitting layer, the light emitting layer comprising a gallium nitride-based semiconductor;
growing a first contact layer on the light emitting layer, the first contact layer comprising a p-type gallium nitride-based semiconductor;
after changing amount of p-type dopant supplied in the growth of the first contact layer, growing a second contact layer on the first contact layer, the second contact layer comprising a p-type gallium nitride-based semiconductor; and
forming a metal electrode on the second contact layer,
a p-type gallium nitride-based semiconductor of the first contact layer being the same as a p-type gallium nitride-based semiconductor of the second contact layer,
amount of p-type dopant supplied to a growth reactor in the growth of the second contact layer being larger than amount of p-type dopant supplied to a growth reactor in the growth of the first contact layer,
a growth temperature for the first contact layer and the second contact layer being higher than a growth temperature of an active layer in the light emitting layer,
a difference between the growth temperature for the first contact layer and the second contact layer and the growth temperature for the active layer being in a range of 100 degrees Celsius to 350 degrees Celsius,
the second contact layer being in direct contact with the metal electrode,
the first contact layer being in direct contact with the second layer,
an interface between the first contact layer and the second contact layer tilting at an angle of not less than 50 degrees and smaller than 130 degrees from a plane orthogonal to a reference axis, the reference axis extending along a c-axis thereof,
the light emitting layer emitting light, the light having a wavelength in a range of 480 to 600 nm, and
the second contact layer has a thickness in a range of 1 to 50 nm.

14. The method of fabricating a group-III nitride semiconductor device according to Claim 13, wherein the second contact layer has a thickness in a range of 1 to 20 nm.

15. The method of fabricating a group-III nitride semiconductor device according to Claim 13 or 14, further comprising the step of growing a cladding layer of a p-type gallium nitride-based semiconductor,
wherein
the cladding layer being grown after the light emitting layer has been grown,
the first contact layer and the second contact layer being grown after the cladding layer has been grown,
the cladding layer is provided between the light emitting layer and the first contact layer,
a bandgap of the cladding layer being greater than a bandgap of the first contact layer, and
the first contact layer being in direct contact with the cladding layer.

16. The method of fabricating a group-III nitride semiconductor device according to Claim 15, further comprising the step of preparing a substrate, the substrate comprising a gallium nitride-based semiconductor,
wherein
the cladding layer is grown on the substrate,
the light emitting layer, the cladding layer, the first contact layer, the second contact layer, and the metal electrode are arranged in sequence on a primary surface of the substrate, and
the primary surface tilting at an angle of not less than 50 degrees and smaller than 130 degrees from a plane orthogonal to the reference axis.

17. The method of fabricating a group-III nitride semiconductor device according to any one of Claims 13 to 16, wherein a p-type dopant concentration of the first contact layer is 5×10²⁰ cm⁻³ or lower.

18. The method of fabricating a group-III nitride semiconductor device according to any one of Claims 13 to 17, wherein a p-type dopant concentration of the second contact layer is in a range of 1×10²⁰ to 1×10²¹ cm⁻³.

19. The method of fabricating a group-III nitride semiconductor device according to any one of Claims 13 to 18, wherein the p-type dopant concentration of the first contact layer is within the range of 5×10¹⁸ to 5×10¹⁹ cm⁻³,

20. The method of fabricating a group-III nitride semiconductor device according to any one of Claims 17 to 19, wherein the p-type dopant comprises magnesium.

21. The method of fabricating a group-III nitride semiconductor device according to any one of Claims 13 to 20, wherein the first contact layer comprises gallium nitride and the second contact layer comprises gallium nitride.

22. The method of fabricating a group-III nitride semiconductor device according to any one of Claims 13 to 20, wherein the first contact layer and the second contact layer comprise InₓAl_{y}Ga_{1-x-y}N (0≤x≤1, 0≤y≤1, 0≤1-x-y).

23. The method of fabricating a group-III nitride semiconductor device according to any one of Claims 13 to 22, wherein the light emitting layer comprises InₓGa₁₋ₓN (0.15≤x<0.50).

24. The method of fabricating a group-III nitride semiconductor device according to any one of Claims 13 to 23, wherein the metal electrode comprises one of palladium, gold, and an alloy of nickel and gold.

25. The group-III nitride semiconductor device according to any one of Claims 1 to 12, wherein a carbon impurity concentration of the first contact layer is not more than 1×10¹⁷ cm⁻³.

26. The group-III nitride semiconductor device according to Claim 4, wherein the primary surface of the substrate tilts at an angle of not less than 70 degrees and smaller than 80 degrees from a plane orthogonal to the reference axis.

27. The group-III nitride semiconductor device according to Claim 4, wherein the primary surface of the substrate tilts at an angle of not less than 100 degrees and smaller than 110 degrees from a surface orthogonal to the reference axis.

28. The method of fabricating a group-III nitride semiconductor device according to any one of Claims 13 to 24, wherein
a growth rate of the first contact layer is not larger than 1 µm/hour,
a growth rate of the second contact layer is not larger than 0.1 µm/hour, and
the growth rate of the second contact layer is lower than the growth rate of the first contact layer.

29. The method of fabricating a group-III nitride semiconductor device according to any one of Claims 13 to 24 and 28, wherein the first contact layer and the second contact layer are grown in an atmosphere having a hydrogen content of not less than 20%.

30. The method of fabricating a group-III nitride semiconductor device according to any one of Claims 13 to 24, 28, and 29, wherein a carbon impurity concentration of the first contact layer is not more than 1×10¹⁷ cm⁻³.

31. The method of fabricating a group-III nitride semiconductor device according to any one of Claims 13 to 24 and 28 to 30, wherein a difference between the growth temperature of the first contact layer and second contact layer and the growth temperature of the active layer is in a range of 100 degrees Celsius to 250 degrees Celsius,

32. The method of fabricating a group-III nitride semiconductor device according to Claim 16, wherein the primary surface of the substrate tilts at an angle of not less than 70 degrees and smaller than 80 degrees from a plane orthogonal to the reference axis.

33. The method of fabricating a group-III nitride semiconductor device according to Claim 16, wherein the primary surface of the substrate tilts at an angle of not less than 100 degrees and smaller than 110 degrees from a plane orthogonal to the reference axis.

34. The method of fabricating a group-III nitride semiconductor device according to any one of Claims 13 to 24 and 28 to 33, wherein a growth temperature of the active layer is not less than 650 degrees Celsius and lower than 800 degrees Celsius.
